(19) Europäisches Patentamt
European Patent Office
Office européen des brevets

(11) EP 2 778 782 B1

(12) **EUROPEAN PATENT SPECIFICATION**

(45) Date of publication and mention of the grant of the patent:
**30.12.2015 Bulletin 2015/53**

(51) Int Cl.:
***G03F 7/09*** *(2006.01)* ***B41C 1/10*** *(2006.01)*

(21) Application number: **13158972.3**

(22) Date of filing: **13.03.2013**

(54) **Negative working radiation-sensitive elements**

Negativ arbeitende strahlungsempfindliche Elemente

Éléments sensibles au rayonnement à travail négatif

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**17.09.2014 Bulletin 2014/38**

(73) Proprietor: **Kodak Graphic Communications GmbH**
**70327 Stuttgart (DE)**

(72) Inventors:
- **Simpson, Christopher**
  **37520 Osterode (DE)**
- **Dwars, Udo**
  **37412 Herzberg (DE)**
- **Baumann, Harald**
  **37520 Osterode (DE)**

(74) Representative: **Vossius & Partner**
**Patentanwälte Rechtsanwälte mbB**
**Siebertstrasse 3**
**81675 München (DE)**

(56) References cited:
**EP-A1- 1 653 281**
**WO-A1-2009/004948**
**US-A- 2 940 948**
**US-A- 5 821 030**
**US-A1- 2007 142 620**
**US-A1- 2008 299 488**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 778 782 B1

## Description

The present invention relates to negative working radiation-sensitive elements like lithographic printing plate precursors with an overcoat acting as oxygen barrier in particular elements which contain a very low amount of alkali and alkaline earth metal ions in the coatings ; the invention also relates to a method for preparing such elements and a method for imaging such elements.

Lithographic printing is based on the immiscibility of oil and water, wherein the oily material or the printing ink is preferably accepted by the image area, and the water or fountain solution is preferably accepted by the non-image area. When an appropriately produced surface is moistened with water and a printing ink is applied, the background or non-image area accepts the water and repels the printing ink, while the image area accepts the printing ink and repels the water. When the printing ink is first transferred to an intermediate material, referred to as blanket, which then in turn transfers the printing ink onto the surface of the material on which the image is to be formed this is referred to as offset lithography.

A frequently used type of lithographic printing plate precursor comprises a photosensitive coating applied onto a substrate on aluminum basis. The coating can react to radiation such that the exposed portion becomes so soluble that it is removed during the developing process. Such a plate is referred to as positive working. On the other hand, a plate is referred to as negative working if the exposed portion of the coating is hardened by the radiation. In both cases, the remaining image area accepts printing ink, i.e. is oleophilic, and the non-image area (background) accepts water, i.e. is hydrophilic.

The plates can be imagewise exposed through a film with clear and opaque areas or digitally without a film e.g. by lasers.

Usually, a substrate, in particular an aluminum substrate with aluminum oxide layer, is provided with a hydrophilic protective layer (also referred to as "interlayer") before the radiation-sensitive coating is applied. This hydrophilic layer improves the water acceptance of the (non-printing) background areas of a lithographic printing plate and improves the repulsion of the printing ink in these areas. A suitable hydrophilic protective layer also ensures that during developing the soluble portions of the radiation-sensitive layer are removed easily and residue-free from the substrate so that clean background areas are obtained during printing. Without such a residue-free removal, what is referred to as toning would occur during printing, i.e. the background areas would accept printing ink.

Sometimes water-soluble polymers are used as temporary coatings (also called "overcoat") on the radiation-sensitive coatings of lithographic printing plate precursors, especially when the precursor has an oxygen-sensitive coating like a photopolymerizable coating. The water-soluble polymers have the function of protecting the coating from atmospheric oxygen during storage, exposure and in particular during the time between exposure and further processing (development and the like). During that time period the temporary coating has to exhibit a sufficient adhesion to the light-sensitive coating so that safe handling (manufacture, packing, transport, exposure etc.) is guaranteed without tearing of the layers. Prior to the development the overcoat can be removed, preferably by washing with water or the overcoat is dissolved within the developer together with the non-image parts; in any case it is required that the overcoat is then completely removed.

WO 2008/150441 discloses imageable elements with an IR-sensitive composition comprising a free radically polymerizable component, an iodonium borate initiator composition, a radiation absorbing cyanine dye, and a polymeric binder, and an oxygen barrier overcoat predominantly comprising poly(vinyl alcohol). The shelflife of such elements was found to be insufficient for ourdays' requirements.

US 7,332,253 discloses imageable elements with a radiation-sensitive composition comprising a free radically polymerizable component, an iodonium borate initiator composition, a radiation absorbing component and a polymeric binder with allyl side groups, and optionally an oxygen barrier overcoat. The shelflife of such elements is not sufficient in ourdays.

EP 2 098 367 discloses a negative-working imageable element with a radiation-sensitive composition comprising

(a) a sensitizer dye capable of absorbing radiation of the range of 700 to 1200 nm
(b) an initiator generating radicals in interacting with the exposed sensitizer
(c) a free radical polymerizable component, and
(d) optionally a polymeric binder,

wherein the sensitizer dye is a cationic dye having a tetraarylborate anion and the initiator is an onium compound selected from diaryliodonium tetraarylborates, triarylsulfonium tetraarylborates, diazonium tetraarylborates, phosphonium tetraarylborates, and N-heterocyclic onium tetraarylborates, wherein N is substituted with -OR wherein R is an optionally substituted hydrocarbyl group. The shelflife of such an element, although acceptable, does not satisfy higher demands.

EP 0 732 625 discloses a process for the production of three-dimensional articles in a stereolithographic bath which process comprises the step of sequentially irradiating a plurality of layers of a liquid radiation-curable composition

comprising a cationically polymerizable compound and a photoinitiator for cationic polymerization. The improvement of stabilizing said composition in said stereolithographic bath against a premature commencement of the polymerization associated with an unintended increase of the viscosity of the composition during the time period of its use comprises bringing a basic ion exchanger material into contact with said composition, for a time sufficient to effect said stabilization. The document does not give any hint to the use of acidic ion exchangers. Furthermore, it does not refer to imageable elements like lithographic printing plate precursors comprising a free radical polymerizable radiation-sensitive coating.

WO 95/12625 discloses a process for removal of residual metallic, ash-producing residues from poly(vinyl alcohol) polymer by using ion exchange resins. No reference to imageable elements is found in this document, let alone the shelflife of such elements.

WO2009/004948 discloses a photosensitive lithographic printing plate material comprising a protective layer containing polyvinyl alcohol and having a metal acetate content that has been controlled.

It was the object of the present invention to provide imageable elements comprising a radiation-sensitive negative working layer, and an overcoat over the negative working layer, which show an excellent shelflife and at the same time good printing quality if the elements are precursors of printing plates.

The present inventors surprisingly found that this object is achieved by a negative working radiation-sensitive element comprising:

(a) a substrate,
(b) a radiation-sensitive coating over the substrate, the coating comprising:

(i) a free radical polymerizable component,
(ii) a radiation absorbing sensitizer, and
(iii) a coinitiator,

and
(c) an overcoat as oxygen barrier layer comprising a polyvinyl alcohol,

characterized in that the total content of alkali metals and alkali-earth metals in the coating material removed by 60s soaking of a sample of the element in deionized water at 22°C is equal to or below 0.5 mg/$m^2$ radiation sensitive element when normalized to a dry layer weight of 1 g/$m^2$ of the removed coating material.

*DEFINITIONS*

Unless the context indicates otherwise, the various components described herein such as "polymeric binder", "initiator", "free radically polymerizable component", "radiation absorbing compound", and similar terms also refer to mixtures of such components. Thus, the use of the articles "a", "an", and "the" is not necessarily meant to refer to only a single component.

Moreover, unless otherwise indicated, percentages refer to percents by total dry weight, for example, weight % based on total solids of either an imageable layer or radiation-sensitive composition. Unless otherwise indicated, the percentages can be the same for either the dry imageable layer or the total solids of radiation-sensitive composition. The same applies to any percentages mentioned below of the overcoat.

The term "polymer" refers to high and low molecular weight polymers including oligomers, homopolymers, and copolymers, which are defined for this invention to have a molecular weight of at least 500.

The term "copolymer" refers to polymers that are derived from two or more different monomers.

Within this invention the expression (meth)acrylic acid includes acrylic acid and methacrylic acid; the same applies to (meth)acrylate and similar expressions.

Within this invention the expression "radiation-sensitive coating" is used interchangeable with the expression "imageable coating"; it can consist of one or more layers and can be obtained by applying a single coating composition to the substrate or two or more coating compositions which are the same or different.

*Radiation-sensitive elements*

The negative working elements of the present invention can be sensitive to UV/VIS radiation or IR radiation. In general, the negative working elements comprise: (i) a substrate, (ii) a negative-working radiation-sensitive coating and (iii) an oxygen barrier layer as overcoat and preferably consist of (i), (ii) and (iii) which are described in detail below.

The negative working elements of the present invention are for instance precursors of printing plates (e.g. precursors of lithographic printing plates and precursors of flexographic printing plates), precursors of color proofing materials, precursors of color filters, and precursors of printed circuit boards; preferable the negative working elements

are precursors of printing plates, more preferably precursors of lithographic printing plates.

*Substrates*

The substrate used for the elements of the present invention is preferably a dimensionally stable plate or foil-shaped material like one that has already been used as a substrate for printing matter. Examples of such substrates include paper, paper coated with plastic materials (such as polyethylene, polypropylene, polystyrene), a metal plate or foil, such as e.g. aluminum (including aluminum alloys), zinc and copper plates, plastic films made e.g. from cellulose diacetate, cellulose triacetate, cellulose propionate, cellulose acetate, cellulose acetatebutyrate, cellulose nitrate, polyethylene terephthalate, polyethylene, polystyrene, polypropylene, polycarbonate and polyvinyl acetate, and a laminated material made from paper or a plastic film and one of the above-mentioned metals, or a paper/plastic film that has been metallized by vapor deposition. Among these substrates, an aluminum plate or foil is especially preferred for the present invention since it shows a remarkable degree of dimensional stability, is inexpensive and furthermore exhibits excellent adhesion to the radiation-sensitive coating. Furthermore, a composite film can be used wherein an aluminum foil has been laminated onto a plastic film, such as e.g. a polyethylene terephthalate film, or paper, or a plastic film onto which aluminum has been applied by means of vapor deposition. Preferred substrates - in particular for printing plate precursors - are metal substrates, wherein the term "metal substrate" as used herein also encompasses composite films with the upper-most layer being a metal layer or foil.

A metal substrate, in particular an aluminum substrate, is preferably subjected to a surface treatment, for example graining by brushing in a dry state or brushing with abrasive suspensions, or electrochemical graining, e.g. by means of a hydrochloric acid electrolyte or $HNO_3$, and optionally anodizing, e.g. in sulfuric acid or phosphoric acid. According to a preferred embodiment the metal substrate comprises an $Al_2O_3$-, ZnO-, $SiO_2$- or $TiO_2$-layer. The roughness of the substrate surface on the image layer side expressed by Ra-value is preferably 0.1 to 1 $\mu$m, more preferably 0.2 to 0.8$\mu$m.

An aluminum foil which preferably has a thickness of 0.1 to 0.7 mm, more preferred 0.15 to 0.5 mm, is an especially preferred substrate for the elements of the present invention, in particular precursors of lithographic printing plates. It is preferred that the foil be grained (preferably electrochemically, for instance in hydrochloric acid or nitric acid) and then show an average roughness of 0.2 to 1 $\mu$m, especially preferred 0.3 to 0.8 $\mu$m.

According to an especially preferred embodiment, the grained aluminum foil was furthermore anodized (for instance in sulfuric acid). The layer weight of the resulting aluminum oxide is preferably 1.5 to 5 $g/m^2$, especially preferred 2 to 4 $g/m^2$.

A metal substrate can additionally be subjected to a posttreatment (so called "sealing") with an aqueous solution of e.g. alkali metal silicate, calcium zirconium fluoride, hexafluorosilicic acid, phosphate/fluoride, polyvinylphosphonic acid, vinylphosphonic acid copolymers, or phosphonic acid thereby providing a hydrophilizing layer (also referred to as "interlayer") on its surface.

The details of the above-mentioned substrate treatments are well known to the person skilled in the art.

Any feature, preferred feature and more preferred feature of the substrate as described above can be combined with any feature, preferred feature or more/most preferred feature described below for the radiation-sensitive coating and/or oxygen barrier layer.

*Negative working radiation-sensitive coating*

The negative working coating applied onto the substrate comprises (a) a free radical polymerizable compound or a mixture thereof, (b) one or more radiation absorbing sensitizer(s) which absorb(s) radiation of a wavelength in the range of 250 to 1,200 nm and (c) at least one coinitiator.

Details of negative-working lithographic printing plate precursors useful in the present invention are described for example, in EP Patent Publications 924,570A1 (Fujimaki et al.), and EP 1,449,650A1 (Goto), and U.S. Patents 4,511,645 (Koike et al.), 6,027,857 (Li et al.), 6,309,792 (Hauck et al.), 6,899,994 (Huang et al.), 7,045,271 (Tao et al.), 7,261,998 (Hayashi et al.), 7,279,255 (Tao et al.), 7,291,438 (Sakurai et al.), 7,326,521 (Tao et al.), 7,332,253 (Tao et al.), 7,442,486 (Baumann et al.), 7,452,638 (Yu et al.), 7,524,614 (Tao et al.), 7,560,221 (Timpe et al.), 7,574,959 (Baumann et al.), and 7,615,323 (Strehmel et al.), and U.S. Patent Application Publications 2003/0064318 (Huang et al.), 2004/0265736 (Aoshima et al.), and 2005/0266349 (Van Damme et al.). Other useful negative-working compositions and elements are described for example in U.S. Patents 6,232,038 (Takasaki) and 6,514,657 (Sakurai et al.) and U.S. Patent Publication 2009/0092923 (Hayashi).

The negative working coating of the precursors according to the present invention is subjected to free radical polymerization upon exposure.

*Sensitizer*

The radiation-sensitive coating of the imageable elements of the present invention comprises at least one sensitizer.

The sensitizer is selected such that it is capable of significantly absorbing radiation of wavelength in the range in which the radiation source to be used later on during imaging emits; preferably, the sensitizer shows an absorption maximum in that range. Thus, if the radiation-sensitive element is e.g. going to be imaged by means of an IR laser, the sensitizer should essentially absorb radiation in the range of above 750 to 1,200 nm (preferably 800 to 1100 nm) and preferably shows an absorption maximum in that range. On the other hand, if imaging is to be carried out by means of UV/VIS radiation, the sensitizer should essentially absorb radiation in the range of about 250 to 750 nm (preferably 300 to 550 nm) and preferably shows an absorption maximum in that range.

Suitable sensitizers are known to the person skilled in the art, or it can easily be determined whether significant absorption occurs in the desired wavelength range by means of simple tests (e.g. recording of an absorption spectrum).

Accordingly, the present invention provides in one aspect negative working elements which are sensitive to UV/VIS radiation, i.e. radiation of about 250 to 750 nm (preferably 300 to 550 nm) and in another aspect negative working elements which are sensitive to IR radiation, i.e. radiation of more than 750 to about 1200 nm (preferably 800 to 1100 nm).

A sensitizer as referred to in the present invention is a compound which can absorb radiation when it is exposed but which cannot by itself, i.e. without the addition of coinitiators, form free radicals.

All light-absorbing compounds that are photooxidizable or photoreducible or capable of transferring their excitation energy to receptor molecules are suitable sensitizers for use in the present invention. Examples of such sensitizers include cyanine dyes, merocyanine dyes, oxonol dyes, diarylmethane dyes, triarylmethane dyes, xanthene dyes, coumarin derivatives, ketocoumarin dyes, acridine dyes, phenazine dyes, quinoxaline dyes, pyrrylium dyes or thiapyrrylium dyes, azaanulene dyes (such as phthalocyanines and porphyrines), indigo dyes, anthraquinone dyes, polyarylenes, polyarylpolyenes, 2,5-diphenylisobenzofuranes, 2,5-diarylfuranes, 2,5-diarylthiofuranes, 2,5-diarylpyrroles, 2,5-diarylcyclopentadienes, poly-arylphenylenes, polyaryl-2-pyrazolines, carbonyl compounds such as aromatic ketones or quinones, e.g. benzophenone derivatives, Michler's ketone, thioxanthone derivatives, anthraquinone derivatives and fluorenone derivatives.

Coumarin sensitizers of formula (I) are for example suitable for the near UV range of the electromagnetic spectrum:

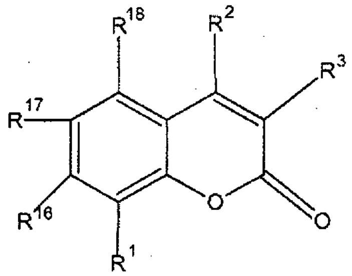

(I)

wherein

$R^1$, $R^{16}$, $R^{17}$ and $R^{18}$ are independently selected from -H, a halogen atom, $C_1$-$C_{20}$ alkyl, -OH, -O-$R^4$ and -$NR^5R^6$, wherein $R^4$ is $C_1$-$C_{20}$ alkyl, $C_5$-$C_{10}$ aryl or $C_6$-$C_{30}$ aralkyl (preferably $C_1$-$C_6$ alkyl) and $R^5$ and $R^6$ are independently selected from a hydrogen atom and $C_1$-$C_{20}$ alkyl,

or $R^1$ and $R^{16}$, $R^{16}$ and $R^{17}$ or $R^{17}$ and $R^{18}$ together form a 5- or 6-membered heterocyclic ring with a heteroatom, selected from N and O, in one or both positions adjacent to the phenyl ring shown in formula (I),

or $R^{16}$ or $R^{17}$ forms, together with its two adjacent substituents, a 5- or 6-membered heterocyclic ring with a heteroatom, selected from N and O, in one or both positions adjacent to the phenyl ring shown in formula (I),

wherein each formed 5- or 6-membered heterocyclic ring can independently be substituted with one or more $C_1$-$C_6$ alkyl groups,

with the proviso that at least one of $R^1$, $R^{16}$, $R^{17}$ and $R^{18}$ is different from hydrogen and $C_1$-$C_{20}$ alkyl,

$R^2$ is a hydrogen atom, $C_1$-$C_{20}$ alkyl, $C_5$-$C_{10}$ aryl or $C_6$-$C_{30}$ aralkyl and

$R^3$ is a hydrogen atom or a substituent selected from -COOH, -$COOR^7$, -$COR^8$, -$CONR^9R^{10}$, -CN, $C_5$-$C_{10}$ aryl, $C_6$-$C_{30}$ aralkyl, a 5- or 6-membered heterocyclic optionally benzofused group, a group -CH=CH-$R^{12}$ and

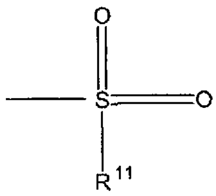

wherein $R^7$ is $C_1$-$C_{20}$ alkyl, $R^8$ is $C_1$-$C_{20}$ alkyl or a 5- or 6-membered heterocyclic group, $R^9$ and $R^{10}$ are independently selected from a hydrogen atom and $C_1$-$C_{20}$ alkyl, $R^{11}$ is $C_1$-$C_{12}$ alkyl or alkenyl, a heterocyclic non-aromatic ring or $C_5$-$C_{20}$ aryl optionally with a heteroatom, selected from O, S and N, and $R^{12}$ is $C_5$-$C_{10}$ aryl or a 5- or 6-membered heterocyclic, optionally aromatic, ring;
or $R^2$ and $R^3$, together with the carbon atoms to which they are bonded, form a 5- or 6-membered, optionally aromatic, ring.

They are described in more detail e.g. in WO 2004/049068 A1.
Furthermore, bisoxazole derivatives and analogues of the formula (II)

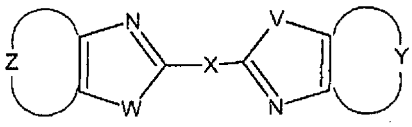

(II)

wherein X is a spacer group comprising at least one C-C double bond conjugated to the heterocycles,
Y and Z independently represent an optionally substituted fused aromatic ring and
V and W are independently selected from O, S and NR, wherein R is an alkyl, aryl or aralkyl group which can optionally be mono- or polysubstituted;

as described in more detail in WO 2004/074929 A2,
and oxazole compounds of the formula (III)

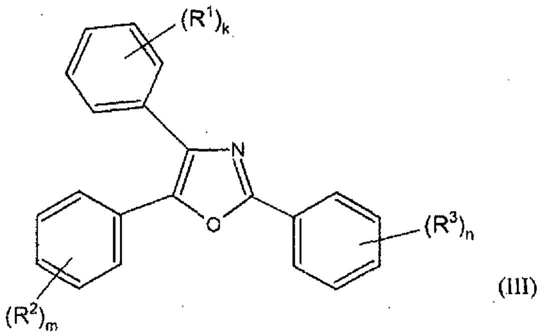

(III)

wherein each $R^1$, $R^2$ and $R^3$ is independently selected from a halogen atom, an optionally substituted alkyl group, an optionally substituted aryl group, which may also be fused, an optionally substituted aralkyl group, a group $-NR^4R^5$ and a group $-OR^6$,
wherein $R^4$ and $R^5$ are independently selected from a hydrogen atom, an alkyl, aryl or aralkyl group,
$R^6$ is an optionally substituted alkyl, aryl or aralkyl group or a hydrogen atom, and k, m and n are independently 0 or an integer from 1 to 5,

as described in detail in WO 2004/074930 A2;
are suitable sensitizers for the UV range.
Further suitable sensitizers for the near UV range are bis-styryl compounds of formula IV

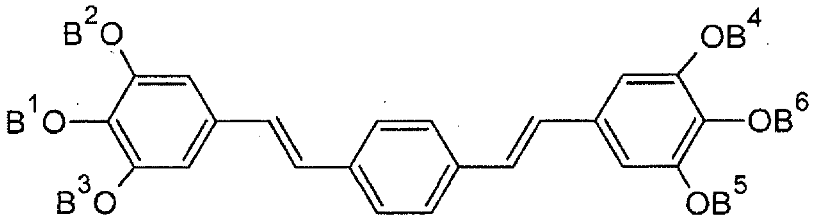

(IV)

wherein $B^1$ to $B^6$ are independently selected from $C_1$ to $C_{20}$ alkyl groups;
and a sensitizer of formula (V) wherein $C^1$ and $C^3$ each represents independently a hydrogen or a monovalent nonmetallic atom group and $C^2$ represents an alkyl group which may have a substituent or an aryl group which may have a substituent and $C^4$ represents an aromatic group which may have a substituent or a heterocyclic group which may have a substituent

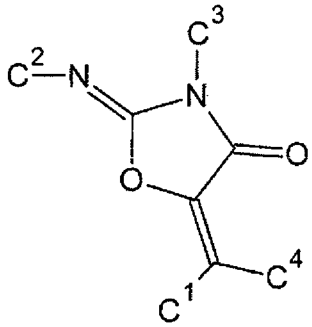

(V)

According to one embodiment of the present invention the sensitizer has a λmax in the UV/VIS range and preferably is selected from formulae I, III, IV and V above.

For IR-sensitive elements, the sensitizers are for example selected from carbon black, phthalocyanine pigments/dyes and pigments/dyes of the polythiophene, squarylium, thiazolium, croconate, merocyanine, cyanine, indolizine, pyrylium or metaldithiolin classes, especially preferred from the cyanine class. The compounds mentioned in Table 1 of US 6,326,122 for example are suitable IR dyes. Further examples can be found in US 4,327,169, US 4,756,993, US 5,156,938, WO 00/29214, US 6,410,207 and EP 1 176 007 A1.

According to one embodiment, a cyanine dye of formula (VI)

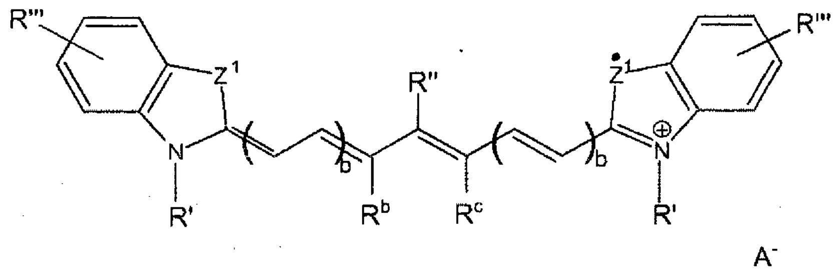

(VI)

is used, wherein

each $Z^1$ independently represents S, O, $NR^a$ or $C(alkyl)_2$;
each R' independently represents an alkyl group, an alkylsulfonate group or an alkylammonium group;
R" represents a halogen atom, $SR^a$, $OR^a$, $SO_2R^a$ or $NR^a{}_2$;
each R"' independently represents a hydrogen atom, an alkyl group, $-COOR^a$, $-OR^a$, $-SR^a$, $-NR^a{}_2$ or a halogen atom; R"' can also be a benzofused ring;
$A^-$ represents an anion;
$R^b$ and $R^c$ either both represent hydrogen atoms or, together with the carbon atoms to which they are attached, form a carbocyclic five- or six-membered ring;
$R^a$ represents a hydrogen atom, an optionally substituted alkyl, an optionally substituted aryl group or an optionally

substituted heteroaryl group;
each b is independently 0, 1, 2 or 3.
If R' represents an alkylsulfonate group, an internal salt can form so that no anion $A^-$ is necessary. If R' represents an alkylammonium group, a second counterion is needed which is the same as or different from $A^-$.

Of the IR dyes of formula (VI), dyes with a symmetrical structure are especially preferred. Examples of especially preferred dyes include:

2-[2-[2-Phenylsulfonyl-3-[2-(1,3-dihydro-1,3,3-trimethyl-2H-indole-2-ylidene)-ethylidene]-1-cyclohexene-1-yl]-ethenyl]-1,3,3-trimethyl-3H-indolium chloride,
2-[2-[2-thiophenyl-3-[2-(1,3-dihydro-1,3,3-trimethyl-2H-indole-2-ylidene)-ethylidene]-1-cyclohexene-1-yl]-ethenyl]-1,3,3-trimethyl-3H-indolium chloride,
2-[2-[2-thiophenyl-3-[2-(1,3-dihydro-1,3,3-trimethyl-2H-indole-2-ylidene)-ethylidene]-1-cyclopentene-1-yl]-ethenyl]-1,3,3-trimethyl-3H-indolium tosylate,
2-[2-[2-chloro-3-[2-(1,3-dihydro-1,3,3-trimethyl-2H-benzo[e]-indole-2-ylidene)-ethylidene]-1-cyclohexene-1-yl]-ethenyl]-1,3,3-trimethyl-1H-benzo[e]-indolium tosylate and
2-[2-[2-chloro-3-[2-ethyl-(3H-benzthiazole-2-ylidene)-ethylidene]-1-cyclohexene-1-yl]-ethenyl]-3-ethyl-benzthiazolium tosylate.

The following compounds are also IR dyes suitable for the present invention; most of them belonging to the cyanine class:

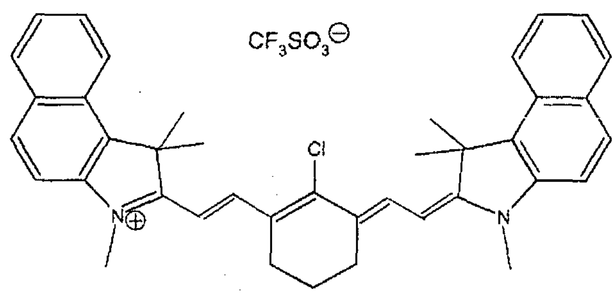

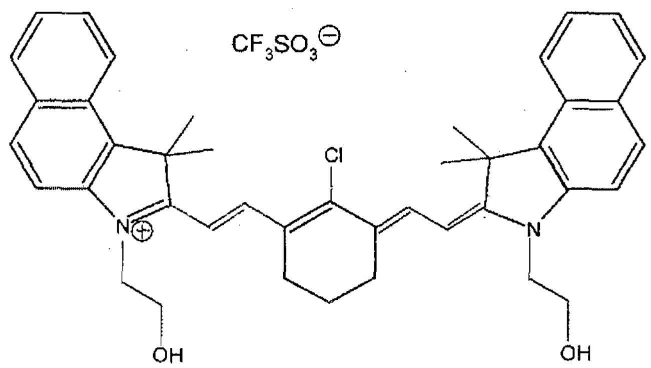

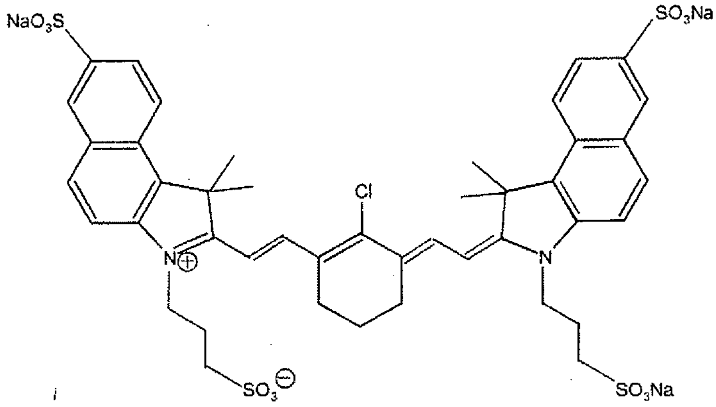

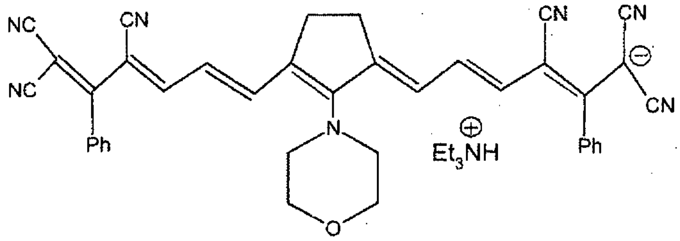

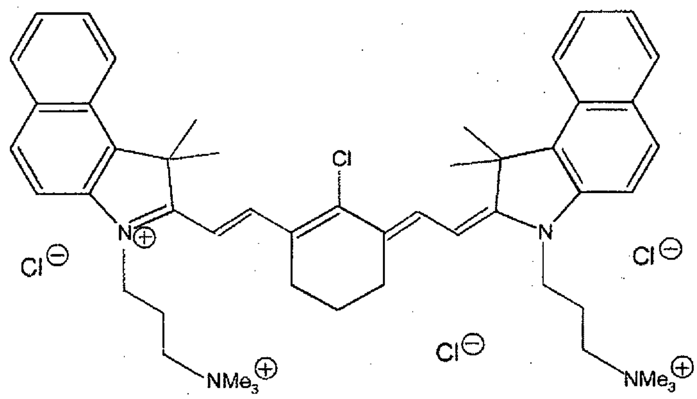

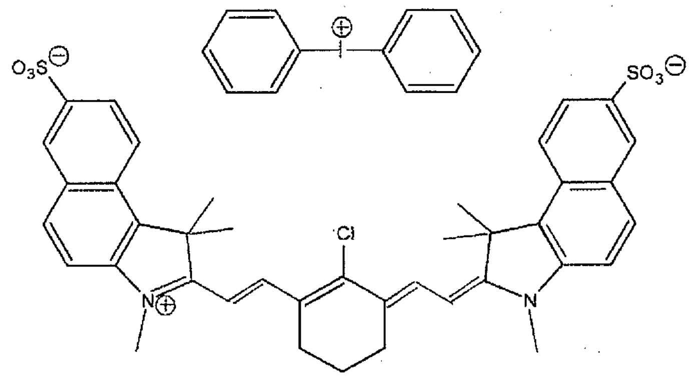

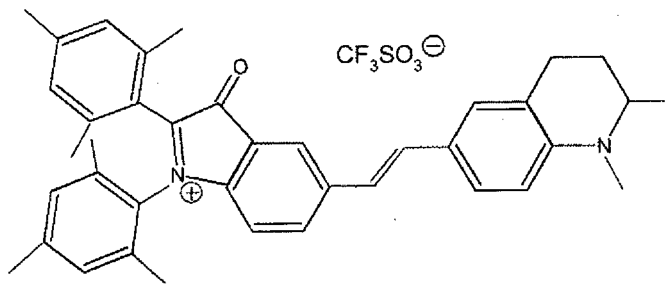

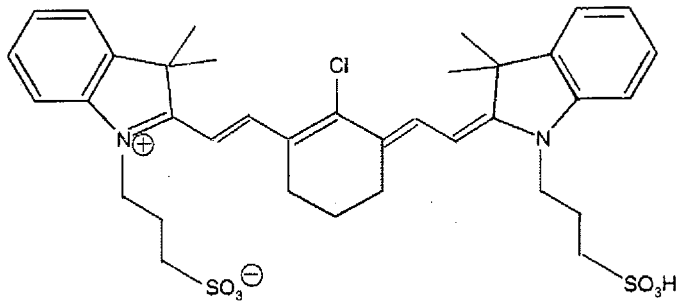

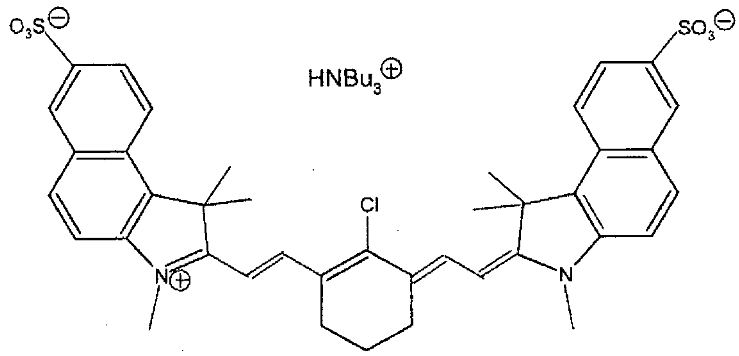

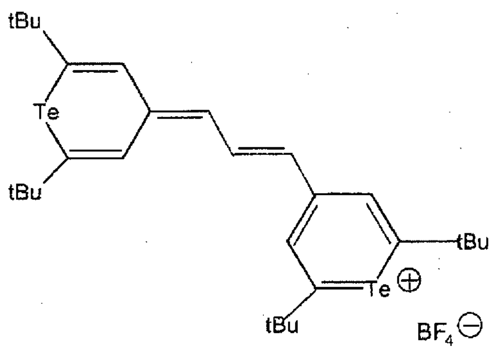

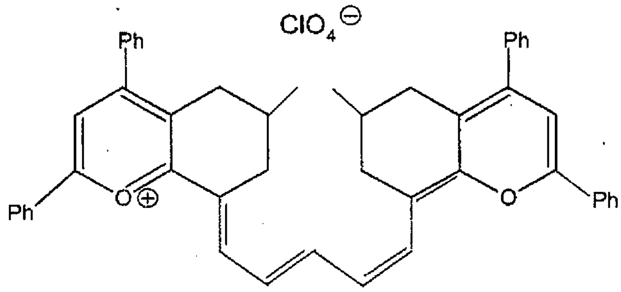

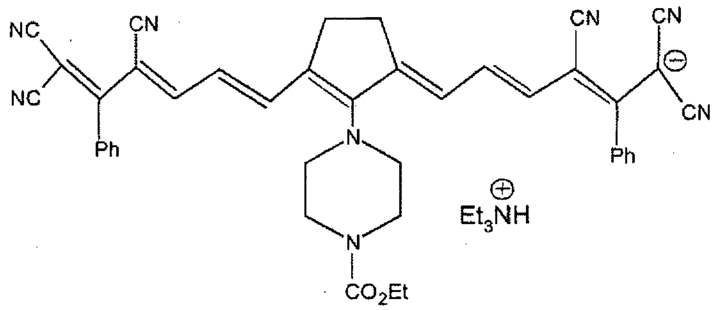

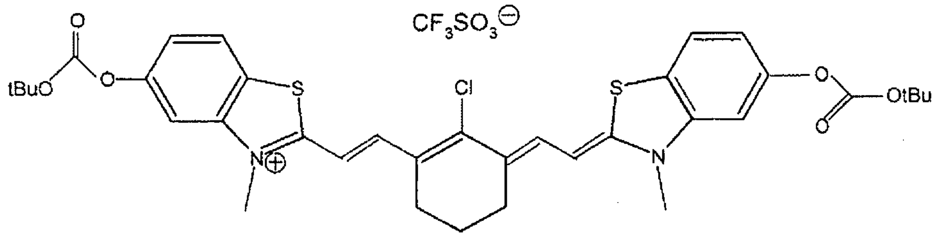

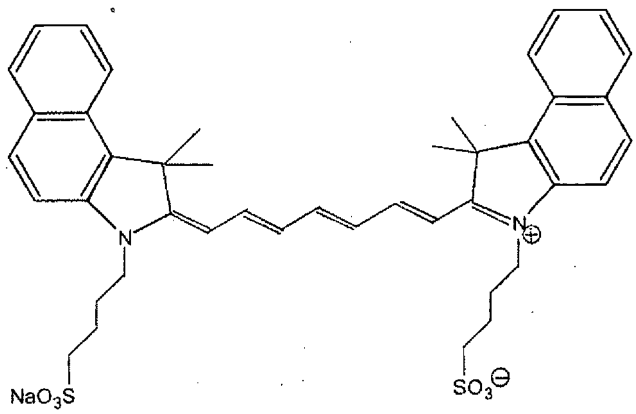

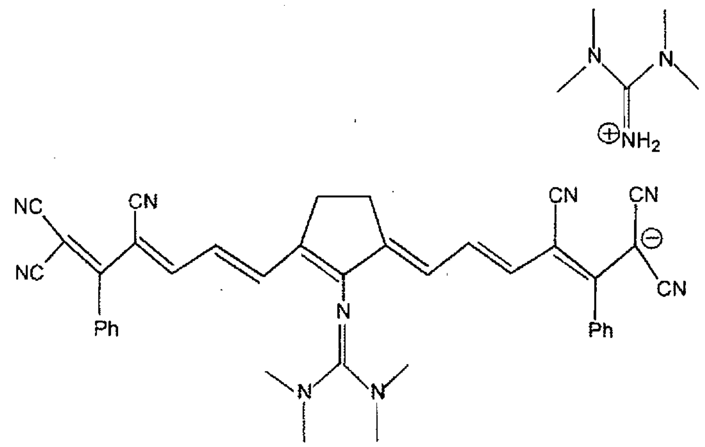

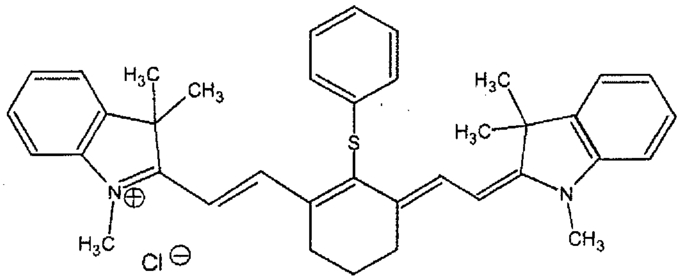

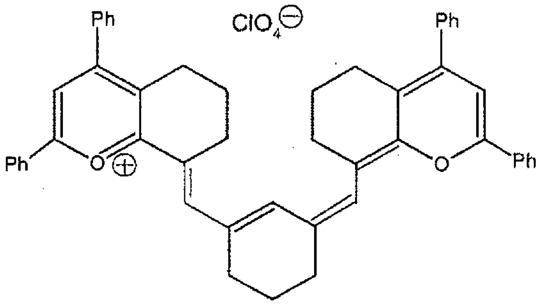

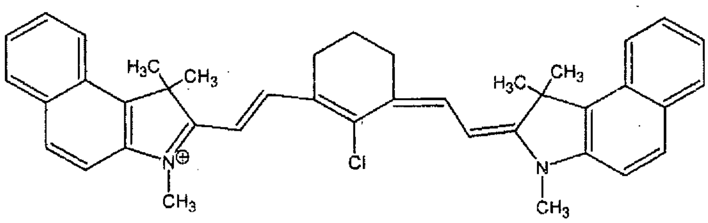

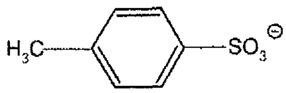

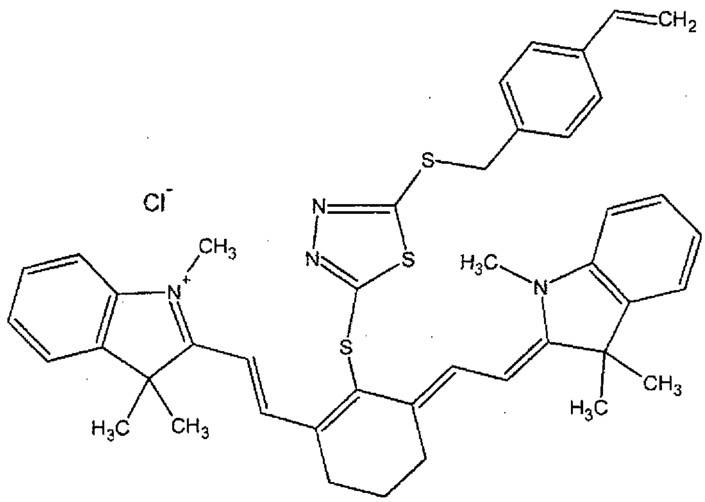

or

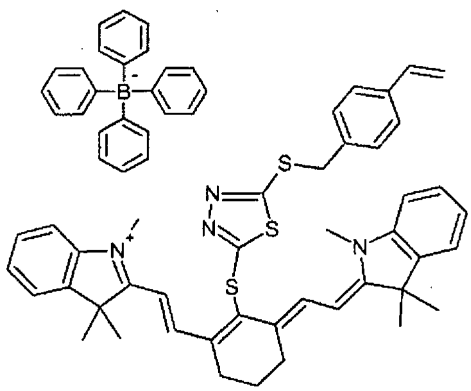

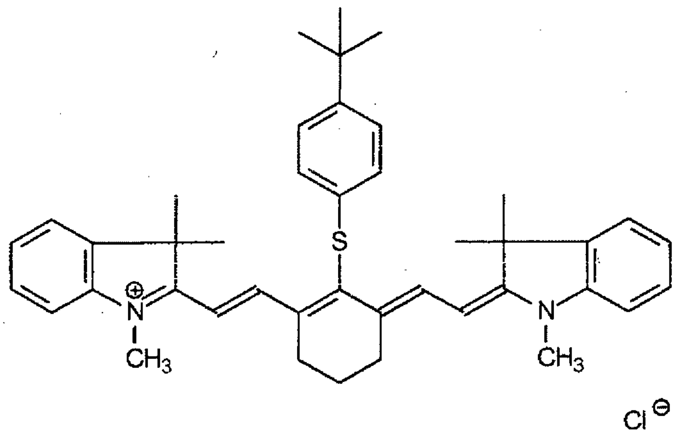

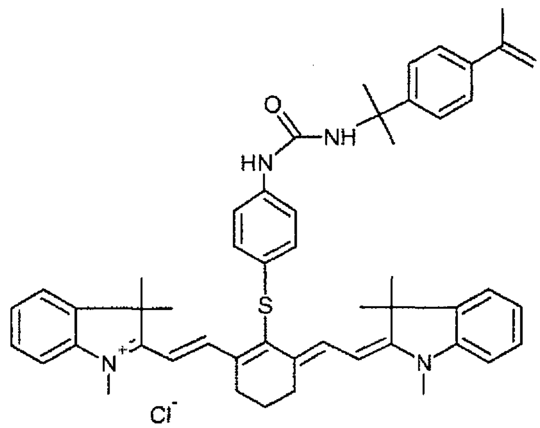

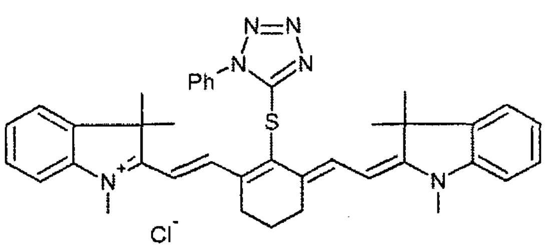

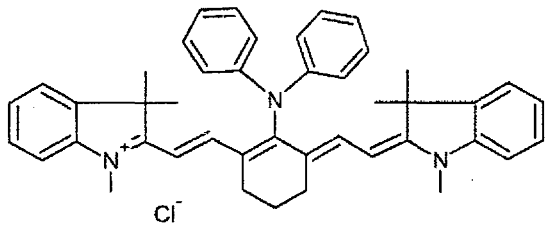

Further suitable examples of sensitizers for IR-sensitive coatings are mentioned in WO2004/041544, WO2000/48836 and DE 10 2004 003143.

In the present invention, one sensitizer or a mixture of two or more can be used.

The amount of sensitizer(s) is not particularly restricted; however, their amount is preferably in the range of 0.2 to 15 wt-%, based on the dry layer weight of the imageable coating, especially preferred 0.5 to 10 wt-%; these ranges apply to both UV sensitizers as well as IR sensitizers.

Any feature or preferred feature of the sensitizer as described above can be combined with any feature or preferred feature described for the coinitiator below.

*Coinitiator*

A coinitiator as referred to in the present invention is a compound that is essentially unable to absorb radiation when irradiated but forms free radicals together with the radiation-absorbing sensitizers used in the present invention.

The interacting mechanism is not clearly understood for all sensitizer/coinitiator combinations. The mechanisms may for instance be an energy transfer from the sensitizer to the coinitiator or an electron transfer mechanism wherein the sensitizer can be the donor or the acceptor.

According to the present invention a coinitiator is present in the radiation-sensitive coating and comprises an onium salt selected form diaryliodonium salts, alkoxypyridinium salts, triarylsulfonium salts and diarylalkylsulfonium salts.

The anions of the onium salts are not specifically limited and can be derived from organic or inorganic acids, triarylalkylborates and tetraarylborates; it is also possible to use an anionic dye as counterion. Especially preferred anions are borates and in particular tetraaryl borates.

Among the suitable diaryliodonium salts, the compounds represented by the following formula (VIII) are preferred :

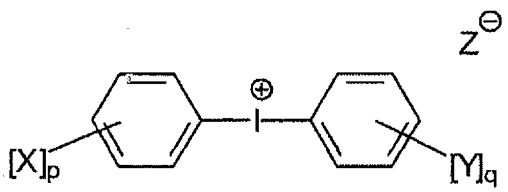

(VIII)

wherein X and Y are independently halo groups (for example, fluoro, chloro, or bromo), substituted or unsubstituted alkyl groups having 1 to 20 carbon atoms (for example, methyl, chloromethyl, ethyl, 2-methoxyethyl, *n*-propyl, isopropyl, isobutyl, *n*-butyl, *t*-butyl, all branched and linear pentyl groups, 1-ethylpentyl, 4-methylpentyl, all hexyl isomers, all octyl isomers, benzyl, 4-methoxybenzyl, *p*-methylbenzyl, all dodecyl isomers, all icosyl isomers, and substituted or unsubstituted mono-and poly-, branched and linear haloalkyls), substituted or unsubstituted alkyloxy having 1 to 20 carbon atoms (for example, substituted or unsubstituted methoxy, ethoxy, *iso*-propoxy, *t*-butoxy, (2-hydroxytetradecyl)oxy, and various other linear and branched alkyleneoxyalkoxy groups), substituted or unsubstituted aryl groups having 6 or 10 carbon atoms in the carbocyclic aromatic ring (such as substituted or unsubstituted phenyl and naphthyl groups including mono- and polyhalophenyl and naphthyl groups), or substituted or unsubstituted cycloalkyl groups having 3 to 8 carbon atoms in the ring structure (for example, substituted or unsubstituted cyclopropyl, cyclopentyl, cyclohexyl, 4-methylcyclohexyl, and cyclooctyl groups). For example, X and Y are independently substituted or unsubstituted alkyl groups having 1 to 8 carbon atoms, alkyloxy groups having 1 to 8 carbon atoms, or cycloalkyl groups having 5 or 6 carbon atoms in the ring, and more preferably, X and Y are independently substituted or unsubstituted alkyl groups having 3 to 6 carbon atoms (and particularly branched alkyl groups having 3 to 6 carbon atoms). Thus, X and Y can be the same or different groups, the various X groups can be the same or different groups, and the various Y groups can be the same or different groups. Both "symmetric" and "asymmetric" diaryliodonium compounds are contemplated by this invention but the "symmetric" compounds are preferred (that is, they have the same groups on both phenyl rings).

In addition, two or more adjacent X or Y groups can be combined to form a fused carbocyclic or heterocyclic ring with the respective phenyl groups.
The X and Y groups can be in any position on the phenyl rings but preferably they are at the 2-or 4-positions, and more preferably at the 4-position, on either or both phenyl rings.
In formula (VIII), p and q are independently 0 or integers of 1 to 5. For example, both p and q can be 1. Thus, it is understood that the carbon atoms in the phenyl rings that are not substituted by X or Y groups have a hydrogen atom at those ring positions.

Z- is an inorganic or organic anion and preferably an organic borate anion represented by the following formula (IX):

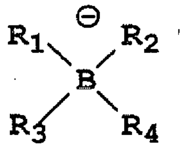

(IX)

wherein $R_1$, $R_2$, $R_3$, and $R_4$ are independently substituted or unsubstituted alkyl, aryl, alkenyl, alkynyl, cycloalkyl or heterocyclyl groups, or two or more of $R_1$, $R_2$, $R_3$ and $R_4$ together form a 5-7 membered heterocyclic ring with a boron atom and optionally one or more further hetero ring atoms selected from nitrogen and oxygen. Preferably $R_1$, $R_2$, $R_3$ and $R_4$ are independently selected from substituted or unsubstituted alkyl groups having 1 to 12 carbon atoms (such as methyl, ethyl, *n*-propyl, *iso*-propyl, *n*-butyl, isobutyl, *t*-butyl, all pentyl isomers, 2-methylpentyl, all hexyl isomers, 2-ethylhexyl, all octyl isomers, 2,4,4-trimethylpentyl, all nonyl isomers, all decyl isomers, all undecyl isomers, all dodecyl isomers, methoxymethyl, and benzyl) other than fluoroalkyl groups, substituted or unsubstituted carbocyclic aryl groups having 6 to 10 carbon atoms in the aromatic ring (such as phenyl, *p*-methylphenyl, 2,4-methoxyphenyl, naphthyl, and pentafluorophenyl groups), substituted or unsubstituted alkenyl groups having 2 to 12 carbon atoms (such as ethenyl, 2-methylethenyl, allyl, vinylbenzyl, acryloyl, and crotonotyl groups), substituted or unsubstituted alkynyl groups having 2 to 12 carbon atoms (such as ethynyl, 2-methylethynyl, and 2,3-propynyl groups), substituted or unsubstituted cycloalkyl groups having 3 to 8 carbon atoms in the ring structure (such as cyclopropyl, cyclopentyl, cyclohexyl, 4-methylcyclohexyl, and cyclooctyl groups), or substituted or unsubstituted heterocyclyl groups having 5 to 10 carbon, oxygen, sulfur, and nitrogen atoms (including both aromatic and non-aromatic groups, such as substituted or unsubstituted pyridyl, pyrimidyl, furanyl, pyrrolyl, imidazolyl, triazolyl, tetrazoylyl, indolyl, quinolinyl, oxadiazolyl, and benzoxazolyl groups); alternatively, two or more of $R_1$, $R_2$, $R_3$, and $R_4$ can be joined together to form a heterocyclic ring with the boron atom, such rings having up to 7 carbon, nitrogen, oxygen, or nitrogen atoms.

For example, $R_1$, $R_2$, $R_3$, and $R_4$ are independently substituted or unsubstituted alkyl or aryl groups as defined above, or at least 3 of $R_1$, $R_2$, $R_3$, and $R_4$ are the same or different substituted or unsubstituted aryl groups (such as substituted or unsubstituted phenyl groups). In some embodiments, all of $R_1$, $R_2$, $R_3$, and $R_4$ are the same or different substituted or unsubstituted aryl groups or, all of the groups are the same substituted or unsubstituted phenyl group. For example, $Z^-$ is a tetraphenyl borate wherein the phenyl groups are substituted or unsubstituted.

Representative iodonium borate compounds include but are not limited to, 4-octyloxyphenyl phenyliodonium tetraphenylborate, [4-[(2-hydroxytetradecyl)-oxy]phenyl]phenyliodonium tetraphenylborate, *bis*(4-*t*-butylphenyl)iodonium tetraphenylborate, 4-methylphenyl-4'-hexylphenyliodonium tetraphenylborate, 4-methylphenyl-4'-cyclohexylphenyliodonium tetraphenylborate, bis(*t*-butylphenyl)iodonium tetrakis(pentafluorophenyl)borate, 4-hexylphenyl-phenyliodonium tetraphenylborate, 4-methylphenyl-4'-cyclohexylphenyliodonium *n*-butyltriphenylborate, 4-cyclohexylphenyl-phenyliodonium tetraphenylborate, 2-methyl-4-*t*-butylphenyl-4'-methylphenyliodonium tetraphenylborate, 4-methylphenyl-4'-pentylphenyl-iodonium tetrakis[3,5-bis(trifluoromethyl)phenyl]-borate, 4-methoxyphenyl-4'-cyclohexyl-phenyliodonium tetrakis(penta-fluorophenyl)borate, 4-methylphenyl-4'-dodecylphenyl-iodonium tetrakis(4-fluorophenyl)borate, bis(dodecylphenyl)iodonium tetrakis(pentafluorophenyl)-borate, and bis(4-*t*-butylphenyl)iodonium tetrakis(1-imidazolyl)borate. Particularly useful compounds include bis(4-*t*-butylphenyl)iodonium tetraphenylborate, 4-methylphenyl-4'-hexylphenyliodonium tetraphenylborate, 2-methyl-4-*t*-butylphenyl-4'-methylphenyliodonium tetraphenylborate, and 4-methylphenyl-4'-cyclohexylphenyliodonium tetraphenylborate.

Many coinitiators can also function as photoinitiators (i.e. compounds which are able to absorb radiation and form radicals) when they are exposed in their absorption band. This way, photosensitive layers can be obtained that are e.g. sensitive over a wide spectral range since the sensitizer covers for instance the long-wavelength spectral range (IR and/or visible range) and the coinitiator (here photoinitiator) covers the short-wavelength spectral range (e.g. the UV range). This effect can be advantageous if the consumer wants to irradiate the same material with different radiation sources. In this case, the coinitiator functions as an actual coinitiator in the sense of the definition given above for the IR or visible range, while it functions as a photoinitiator (which is capable of absorbing radiation and forming free radicals) for the UV range.

In the present invention, one coinitiator or a mixture of coinitiators can be used. If only one coinitiator is used it is preferably selected from onium salts such as those mentioned above. If a mixture of coinitiators is used in the radiation-sensitive coating preferably at least one thereof is an onium salt (i.e. a mixture of different onium salts can be used, or one or more onium salts are used in combination with one or more other kind(s) of coinitiator like those mentioned above).

The amount of coinitiator(s) is not particularly restricted; however, it is preferably in the range of 0.2 to 25 wt-%, based on the dry layer weight of the imageable coating, especially preferred 0.5 to 15 wt-%. If one or more onium salts are used in combination with another kind of coinitiator the amount of the onium salts is preferably at least 0.5 wt%, based on the total amount of coinitiators. If only an onium salt (or mixture of onium salts) is used as coinitiator its amount (total amount in case of a mixture) is preferably in the range of 0.2 to 25 wt% based on the dry layer weight of the imageable coating, more preferred 0.5 to 15 wt%.

*Free-radical polymerizable component*

The radiation sensitive coating of the elements of the present invention comprises a free-radical polymerizable component which has at least two free radically polymerizable groups per molecule.

All monomers or oligomers which comprise at least two C-C double bonds can be used. Suitable compounds are well known to the person skilled in the art and can be used in the present invention without any particular limitations. Esters of acrylic and methacrylic acids, itaconic acid, crotonic and isocrotonic acid, maleic acid and fumaric acid with one or more unsaturated groups in the form of monomers, oligomers or prepolymers are preferred. They may for instance be present in liquid or viscous form. Compounds suitable as monomers include for instance di- or higher esters of acrylic acid or methacrylic acid with polyhydric alcohols such as trimethylol propane triacrylate and trimethacrylate, pentaerythritol triacrylate and trimethacrylate, dipentaerythritolmonohydroxy pentaacrylate and pentamethacrylate, dipentaerythritol hexaacrylate and hexamethacrylate, pentaerythritol tetraacrylate and tetramethacrylate, ditrimethylol propane tetraacrylate and tetramethacrylate, diethyleneglycol diacrylate and dimethacrylate, triethyleneglycol diacrylate and dimethacrylate or tetra-ethyleneglycol diacrylate and dimethacrylate. Suitable oligomers and/or prepolymers are for example urethane acrylates and methacrylates, epoxide acrylates and methacrylates, polyester acrylates and methacrylates, polyether acrylates and methacrylates or unsaturated polyester resins.

Another class of free-radical polymerizable components is the class of urethane acrylates or urethane methacrylates. They are derived either from polyhydroxy compounds like pentaerythritol or glycerol that react with monoisocyanate having acrylate or methacrylates groups, e.g. like isocyanatoethyl methacrylate or isocyanatoethyl acrylate or from polyisocyanates that reacts with monohydroxy compounds carrying acrylate or methacrylate groups. Examples for the latter type are adducts of 1 mole hexamethylene-1,6-diisocyanate and 2 moles hydroxyethyl methacrylate, adducts of 1 mole hexamethylene-1,6-diisocyanate and 2 moles glycerol dimethacrylate, adducts of 1 mole trimethylhexamethylene-1,6-diisocyanate and 2 moles hydroxyethylmethacrylate, and adducts of 1 mole of the biuret of hexamethylene-1,6-diisocyanate with 3 moles of hydroxycompounds having acrylate or methacrylate groups as disclosed in EP 1969426.

Another class of free-radical polymerizable components are compounds that have a molecular weight of 3,000 or less and are reaction products obtained by reacting a diisocyanate with (i) an ethylenically unsaturated compound with one hydroxy group, and at the same time (ii) a saturated organic compound with one NH group and one OH group as disclosed in EP 355387. A representative example for this type of polymerizable compound is the adduct of 2 moles of hexamethylene-1,6-diisocyanate, 1 mole of 2-(2-hydroxyethyl)piperidine and 2 moles of hydroxyethylmethacrylate as described in Preparation Example 1 of US 7,574,959.

The radiation-sensitive coating can also comprise a mixture of different free-radical polymerizable compounds. It is of course possible to use a mixture of different kinds of monomers or oligomers in the coating; furthermore, mixtures of monomers and oligomers can be used in the present invention.

According to one embodiment of the present invention the free-radical polymerizable component is preferably used in an amount of 5 to 70 wt wt-%, based on the dry layer weight of the imageable coating, especially preferred 10 to 50 wt-%.

The above described aspects and preferred aspects of the polymerizable component can be combined with any aspect or preferred aspect described above for the sensitizer and coinitiator as well as the substrate.

*Optional Binders*

Suitable optional polymeric binders are e.g. polymers/copolymers which do not contain radically polymerizable groups and are soluble or dispersible in aqueous alkaline developer, such as e.g. phenolic resins such as novolaks and resols, and copolymers of (meth)acrylic acid, N-phenylmaleimide and (meth)acrylamide (see DE 199 36 331). According to another aspect of the present invention polymers/copolymers which contain ethylenically unsaturated moieties as radically polymerizable groups (often referred to as "reactive binders") can be used as optional binders. It is also within

the present invention to use a mixture of different binders, which may be a mixture of reactive binders, a mixture of non-reactive binders or a mixture of reactive and non-reactive binders.

The total amount of optional binders is preferably 0 to 90 wt%, based on the dry layer weight of the radiation-sensitive coating; according to one embodiment an optional binder is present and its amount is 10 to 80 wt% based on the dry layer weight of the radiation-sensitive coating and according to another embodiment no such optional binder is present.

Useful are for instance random copolymers derived from polyethylene glycol methacrylate/acrylonitrile/styrene monomers in random fashion and in particulate form, dissolved random copolymers derived from carboxyphenyl methacrylamide/acrylonitrile/-methacrylamide/N-phenyl maleimide, random copolymers derived from polyethylene glycol methacrylate/acrylonitrile/vinyl carbazole/styrene/-methacrylic acid, random copolymers derived from N-phenyl maleimide/methacrylamide/methacrylic acid, random copolymers derived from urethane-acrylic intermediate A (the reaction product of *p*-toluene sulfonyl isocyanate and hydroxyl ethyl methaerylate)/acrylonitrile/N-phenyl maleimide, and random copolymers derived from N-methoxymethyl methacrylamide/methacrylic acid/acrylonitrile/*n*-phenylmaleimide. By "random" copolymers, we mean the conventional use of the term, that is, the structural units in the polymer hydrophobic backbone that are derived from the monomers are arranged in random order as opposed to being block copolymers, although two or more of the same structural units can be in a chain incidentally.

Other useful polymeric binders can be selected from those described below that is not an exhaustive list:

I. Polymers formed by polymerization of a combination or mixture of (a) (meth)acrylonitrile, (b) poly(alkylene oxide) esters of (meth)acrylic acid, and optionally (c) (meth)acrylic acid, (meth)acrylate esters, styrene and its derivatives, and (meth)acrylamide as described for example in U.S. Patent 7,326,521 (Tao et al.). Some particularly useful polymeric binders in this class are derived from one or more (meth)acrylic acids, (meth)acrylate esters, styrene and its derivatives, vinyl carbazoles, and poly(alkylene oxide) (meth)acrylates.

II. Polymers having C-C double bonds. Examples are polymers having pendant allyl ester groups as described in U.S. Patent 7,332,253 (Tao et al.). Such polymers can also include pendant cyano groups or have recurring units derived from a variety of other monomers as described in Col. 8, line 31 to Col. 10, line 3 of the noted patent.
In polymeric binders that have one or more ethylenically unsaturated pendant groups (reactive vinyl groups) attached to the polymer backbone the reactive groups are capable of undergoing polymerizable or crosslinking in the presence of free radicals. The pendant groups can be directly attached to the polymer backbone with a carbon-carbon direct bond, or through a linking group that is not particularly limited. The reactive vinyl groups can be substituted with at least one halogen atom, carboxy group, nitro group, cyano group, amide group, or alkyl, aryl, alkoxy, or aryloxy group, and particularly one or more alkyl groups. In some embodiments, the reactive vinyl group is attached to the polymer backbone through a phenylene group as described, for example, in U.S. Patent 6,569,603 (Furukawa et al.). Other useful polymeric binders have vinyl groups in pendant groups that are described, for example in EP 1,182,033A1 (Fujimaki et al.) and U.S. Patents 4,874,686 (Urabe et al.), 6,916,595 (Fujimaki et al.), and 7,041,416 (Wakata et al.), especially with respect to the general formulae (1) through (3) noted in EP 1,182,033A1.

III. Polymers having all carbon backbones wherein at least 40 mol % and up to and including 100 mol % (and typically at least 40 mol % and up to and including 50 mol %) of the carbon atoms forming the all carbon backbones are tertiary carbon atoms, and the remaining carbon atoms in the all carbon backbone being non-tertiary carbon atoms. Further details of such polymeric binders are provided in U.S. Patent 7732118 (Tao et al.).

IV. Polymeric binders can have pendant 1H-tetrazole groups as described in U.S. Patent Application Publication 2009-0142695 (Baumann et al.).

V. Still other useful polymeric binders include but are not limited to, (meth)acrylic acid and acid ester resins [such as (meth)acrylates], polyvinyl acetals, phenolic resins, polymers derived from styrene, N-substituted cyclic imides or maleic anhydrides, such as those described in EP 1,182,033 (noted above) and U.S. Patents 6,309,792 (Hauck et al.), 6,352,812 (Shimazu et al.), 6,569,603 (noted above), and 6,893,797 (Munnelly et al.). Also useful are the vinyl carbazole polymers described in U.S. Patent 7,175,949 (Tao et al.).

Other useful polymeric binders are particulate poly(urethane-acrylic) hybrids that are distributed (usually uniformly) throughout the imageable layer. Each of these hybrids has a molecular weight of at least 50,000 and up to and including 500,000 and the particles have an average particle size of at least 10 and up to and including 10,000 nm (typically at least 30 and up to and including 500 nm).

Any aspect or preferred aspect described for the optional binder can be combined with any aspect or preferred aspect of the sensitizer and/or radical forming component and/or coinitiator and/or substrate described above.

*Further optional components*

Independently of whether the element is UV/VIS- or IR-sensitive, the radiation-sensitive coating can further comprise one or more of the following optional components in addition to the above-mentioned essential and optional components.

Dyes or pigments having a high absorption in the visible spectral range can be present in order to increase the contrast ("colorants"). Particularly suitable dyes and pigments are those that dissolve well in the solvent or solvent mixture used for coating or are easily introduced in the dispersed form of a pigment. Suitable contrast dyes include *inter alia* rhodamine dyes, triarylmethane dyes such as Victoria blue R and Victoria blue BO, crystal violet and methyl violet, anthraquinone pigments, azo pigments and phthalocyanine dyes and/or pigments. The colorants are preferably present in an amount of 0 to 15 wt-%, more preferred 0.5 to 10 wt-%, particularly preferred 1.5 to 7 wt-%, based on the dry layer weight.

Furthermore, the radiation-sensitive coating can comprise surfactants (e.g. anionic, cationic, amphoteric or non-ionic surfactants or mixtures thereof). Suitable examples include fluorine-containing polymers, polymers with blocks of ethylene oxide and/or propylene oxide, sorbitol-tri-stearate and alkyl-di-(aminoethyl)-glycines. They are preferably present in an amount of 0 to 10 wt-%, based on the dry layer weight, especially preferred 0.2 to 5 wt-%.

The radiation-sensitive coating can furthermore comprise print-out dyes such as leuco crystal violet, crystal violet lactone or photochromic dyes (e.g. spiropyrans etc.). They are preferably present in an amount of 0 to 15 wt-%, based on the dry layer weight of the radiation-sensitive coating, especially preferred 0.5 to 5 wt-%.

Also, flow improvers can be present in the radiation sensitive coating, such as poly(glycol)ether-modified siloxanes; they are preferably present in an amount of 0 to 1 wt-%, based on the dry layer weight of the radiation-sensitive coating.

The layer(s) can furthermore comprise antioxidants such as e.g. mercapto compounds (2-mercapto-benzimidazole, 2-mercaptobenzthiazole, 2-mercaptobenzoxazole and 3-mercapto-1,2,4-triazole), and triphenylphosphate. They are preferably used in an amount of 0 to 15 wt-%, based on the dry layer weight of the radiation-sensitive coating, especially preferred 0.5 to 5 wt-%. The presence of mercapto compounds is especially preferred for UV-sensitive elements of the present invention.

The radiation-sensitive coating can furthermore comprise anaerobic or aerobic radical polymerization inhibitors.

The anaerobic free radical inhibitors function different from aerobic inhibitors in the absence of oxygen because they are able to react directly with the free radicals. Useful compounds of this type include nitroso compounds (both N- and C-nitroso), N-oxides, and hydroxylamine derivatives. Typical examples include but are not limited to:

C-nitroso compounds such as $C_4$ to $C_{10}$ nitroso alkanes (for example, *t*-nitrosobutane and *t*-nitrosoctane), aromatic C-nitroso compounds (for example, nitrosobenzene, 2-nitrosotoluene, nitrosodurene, 4-nitrosophenol, 1-nitroso-2-naphthole, 2-nitroso-1-naphthole, 4-nitroso-diphenylamine, 3,5-dibromo-4-nitrosobenzenesuifonic acid or salt, and 2-methyl-2-nitroso-propane dimer);

N-nitroso-compounds such as N-nitroso-N-phenyl hydroxylamine and their complexes with cations ($[PhN(NO)O]_mM1$ wherein M1 is ammonium ion, or metal ions of the 3rd-6th period elements of the Groups I-VIII of the Periodic Table, and m is 1 to 4), N-nitrosodiphenylamine, N-nitrosopyrrolidine, N-*t*-butyl-N-nitrosoaniline, N-nitrosodimethylamine, N-nitrosodiethyl-amine, 1-(aminocarbonyl)-1-methyl-2-oxohydrazine, 1-nitrosopiperidine, 4-nitrosomorpholine, N-nitroso-N-methylbutylamine, N-nitroso-N-ethylurea, and N-nitrosohexamethyleneimine;

N-oxides such as 5,5-dimethyl-1-pyrroline N-oxide, $\alpha$-(4-pyridyl N-oxide)-N-*t*-butylnitrone, N-*t*-butyl-$\alpha$-phenylnitrone, and 3,3,5,5-tetramethyl-1-pyrroline N-oxide;

hydroxylamine derivatives such as 1-hydroxy-2,2,6,6-tetramethyl-4-piperidone.

The N-nitroso compounds are particularly useful, including N-nitroso-N-phenyl hydroxylamine and their aluminum or sodium complexes.

The aerobic free radical inhibitors can function as an inhibitor in a free radical polymerizable composition only in the presence of oxygen. These inhibitors have a low inhibiting efficiency in the absence of oxygen. Typical representatives of aerobic free radical inhibitors include phenolic compounds such as phenols including sterically hindered phenols. Examples include but are not limited to, hydroquinone, 4-methoxyphenol (MEHQ), 2,6-di-tert-butyl-4-methylphenol (BHT), 4,4'-bis(2,6-di-tert-butylphenol), 1,3,5-trimethyl-2,4,6-tris(3,5-di-tert-butyl-4-hydroxybenzyl)-benzene, and 3,5-di-tert-butyl-1,2-benzenediol.

A combination of aerobic and anaerobic inhibitors as disclosed in EP 2310909 gives advantage in some cases.

The concentrations of each of the aerobic and anaerobic free radical inhibitors in the radiation-sensitive coating - if present at all - are independently from about 0.001 to about 2 weight %, or from about 0.003 to about 0.5 weight % based on the total dry weight of the radiation-sensitive coating. The molar ratio of the aerobic free radical inhibitor to the anaerobic free radical inhibitor is preferably from about 1:1 to about 200:1.

The radiation-sensitive coating may furthermore comprise organic particles such as crosslinked PE particles, PP particles, polystyrene particles or acrylic particles, inorganic particles such as silica particles or Titanium dioxide particles, organic particles having an inorganic modified surface such as silica coated organic particles, or organically modified inorganic particles such as surface-modified fumed silica particles and sol-gel silica particles such as disclosed in EP 2260351 or particles, the surface of which is modified by an organic compound having at least one ethylenically unsaturated group as disclosed in EP 1880978. The particles - if present at all - are present in an amount of from about 1 to about 40 weight % based on the total dry layer weight of the radiation-sensitive coating, and preferably have an average particle size as measured by SEM of from about 1 to about 2000 nm, preferably 5 to 500 nm. The presence of the particles may provide improved abrasion resistance, reduced tackiness, and various other desired properties.

*Overcoat as Oxygen-barrier*

An oxygen-impermeable overcoat ("oxygen barrier layer") is applied over the radiation sensitive coating (either directly or with one or more intermediate layers between radiation sensitive coating and overcoat); "oxygen-impermeable" does not necessarily mean "impermeable to 100 %" but sufficient for protecting the coating from atmospheric oxygen during storage, exposure and in particular during the time between exposure and further processing in order to avoid undesired image loss. During that time the overcoat has to exhibit sufficient adhesion to the radiation-sensitive coating so that safe handling (manufacture, packing, transport, exposure etc.) is guaranteed without tearing of the layers. In addition to its function as oxygen barrier layer the overcoat also protects the radiation sensitive coating from fingerprints and mechanical damage like scratches.

The overcoat is the outermost layer of the radiation-sensitive element which means that there are no layers disposed over it and it is the first layer in the precursor that is impacted by radiation.

Usually the main component of an overcoat is a polymer that is water-soluble at about room temperature (i.e. within a range of 18 to 25°C) so that the overcoat can be removed by washing with water. A number of water-soluble polymers are described in the literature as being suitable for such overcoats, such as optionally functionalized polyvinyl alcohols; partly saponified polyvinyl acetate having a saponification degree of from 70 to 99% and which can optionally also contain vinylether and vinylacetal units; polyvinyl pyrrolidone and copolymers thereof with vinyl acetate and vinyl ethers; hydroxy alkyl cellulose; gelatin; polyacrylic acid; gum Arabic; polyacryl amide; dextrin; cyclodextrin; copolymers of alkylvinyl ethers and maleic acid anhydride; as well as water-soluble high molecular polymers of ethylene oxide having molecular weights of above 5,000. Most commonly used are optionally functionalized polyvinyl alcohols.

According to the present invention the overcoat comprises an optionally functionalized polyvinyl alcohol. According to one aspect of the present invention the overcoat comprises at least 70 wt% of an optionally functionalized polyvinyl alcohol, preferably at least 80 wt%, more preferably at least 90 wt%, even more preferably at least 99 wt% based on dry layer weight. According to another embodiment the overcoat consists of an optionally functionalized polyvinyl alcohol and more preferably of a polyvinyl alcohol which - besides vinyl alcohol units and vinyl acetate units - does not contain functional groups.

It is also possible to use an optionally functionalized polyvinyl alcohol in combination with another water-soluble polymer as mentioned above.

In some applications it is desired to remove the overcoat during processing of the exposed lithographic plates not in a separate prewash step but together with the non-image areas in the developing step. This type of processing requires high solubility of the overcoat polymer in the developer. It was found that using polyvinyl alcohol (PVA) with acidic side groups like carboxylic acid or sulfonic acid groups (JP2009086514) or hydrophilic side groups like glycol groups (US7928166) or alkylene oxide side chains (EP2275258) in the overcoat results in clean processing at high loading rates.

Another groups of suitable PVAs which are highly soluble in developers are vinyl alcohol copolymers comprising at least one unit of each of the following (a), (b), and (c) recurring units, in any order:

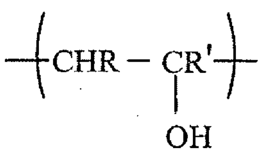

(a)

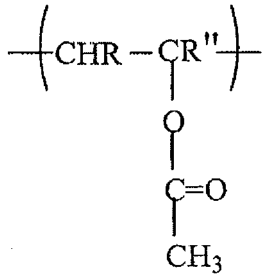

(b)

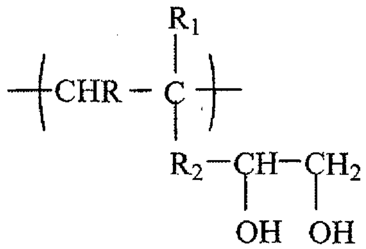

(c)

In these recurring units structures, R, R', and R" are independently hydrogen or a substituted or unsubstituted alkyl group having 1 to 4 carbon atoms, such as substituted or unsubstituted methyl, ethyl, *n*-propyl, *iso*-propyl, *n*-butyl, and t-butyl. Preferably R, R', and R" are independently selected from hydrogen and substituted or unsubstituted methyl, and more preferably each is independently selected from hydrogen and unsubstituted methyl. In still other embodiments, each of R, R', and R" is hydrogen.

$R_1$ is hydrogen or a substituted or unsubstituted alkyl group having 1 to 4 carbon atoms, such as substituted or unsubstituted methyl, ethyl, *n*-propyl, *iso*-propyl, *n*-butyl, and t-butyl. $R_1$ is preferably hydrogen or substituted or unsubstituted methyl, and more preferably hydrogen or unsubstituted methyl. In still other embodiments, $R_1$ is hydrogen.

$R^2$ represents a single bond or a substituted or unsubstituted alkylene or carbocyclic group (which may be saturated or unsaturated). These alkylene groups can have 1 to 4 carbon atoms and can be linear or branched, and the carbocyclic groups can have 5 to 7 carbon ring atoms. $R^2$ is preferably a single bond or a substituted or unsubstituted alkylene group having 1 to 3 carbon atoms, more preferably $R^2$ is a single bond or an unsubstituted methylene or ethylene, and even more preferred a single bond or an unsubstituted methylene.

In the vinyl alcohol copolymers, the (c) recurring units are preferably present in an amount of at least 0.5 mol %, more preferably at least 0.5 mol % and up to and including 20 mol %, even more preferably at least 1 mol % and up to and including 10 mol %, all based on the total recurring units in the vinyl alcohol copolymer.

In a preferred embodiment the (a) recurring units are present in an amount of at least 40 mol % and up to and including 99.4 mol %, the (b) recurring units are present in an amount of at least 0.1 mol % and up to and including 40 mol %, and the (c) recurring units are present in an amount of at least 0.5 mol % and up to and including 20 mol %, based on the total recurring units in the vinyl alcohol copolymer.

In an even more preferred embodiment, the vinyl alcohol copolymers comprise the (a) recurring units in an amount of at least 70 mol % and up to and including 98.8 mol %, the (b) recurring units in an amount of at least 0.1 mol % and up to and including 20 mol %, and the (c) recurring units in an amount of at least 1 mol % and up to and including 10 mol %, based on the total recurring units in the vinyl alcohol copolymer.

To improve the adhesion of a PVA overcoat to the photopolymer layer basic adhesion promoters like poly(1-vinylimidazole) or a copolymer of 1-vinyl-imidazole as described in WO 99/06890 or polyvinyl pyrrolidone or a copolymer thereof can optionally be added; if present, the amount of the adhesion promoters may be 1 to 30% based on the dry weight of the overcoat.

Overcoats are also described in US 3,458,311, US 4,072,527, US 4,072,528, EP 275 147 A1, EP403 096 A1, EP 354 475 A1, EP 465 034 A1 and EP 352 630 A1.

According to one embodiment the overcoat comprises a polyvinyl alcohol but no other polymer like adhesion promoter like poly(vinyl pyrrolidone), poly(vinyl imidazole) and copolymers thereof. Preferably the overcoat consists of a PVA.

According to another embodiment the overcoat comprises a polyvinyl alcohol in combination with poly(vinyl pyrrolidone) or a copolymer of vinyl pyrrolidone.

According to yet another embodiment the overcoat comprises a polyvinyl alcohol in combination with poly(vinyl imidazole) or a copolymer of 1-vinyl imidazole.

Since vinyl alcohol does not exist in free form polyvinyl alcohols (PVA) are so far prepared by large-scale polymerization of vinyl acetate and subsequent hydrolysis (alcoholysis; saponification) with methanol:

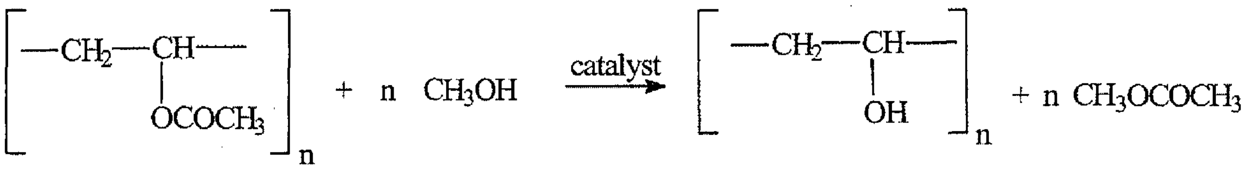

The catalyst used in large-scale processes is in most cases sodium hydroxide resulting in the by-product sodium acetate.

PVAs are commercially available at inexpensive prices.

By varying the catalyst concentration, reaction temperature and reaction time the residual content of acetyl groups in the PVA can be adjusted. Usually the saponification degree of PVAs is from 30 to 99.9 mol%, preferably 75 to 99 mol%.

PVAs can be further characterized by the viscosity of a freshly prepared 4 wt% solution thereof in water. When measured at 20°C it is usually 2.5 to 50 mPa·s, preferably 3 to 15 mPa·s. A Höppler falling-ball viscometer (DIN 53015) can be used for measuring.

Preferred PVAs for use in the present application show a saponification degree of 30 to 99.9 mol% and a viscosity of 2.5 to 50 mPa·s (when a 4 wt% solution in water is measured at 20°C with a Höppler falling-ball viscometer); more preferably the saponification degree is 75 to 99 mol% and the viscosity of a 4% aqueous solution at 20°C is 2.5 to 50 mPa·s (preferably 3 to 15 mPa·s).

Besides PVAs containing only vinyl alcohol units and vinyl acetate units also functionalized PVAs can be used which within this invention are understood as PVAs which in addition contain other functional groups (preferably selected from sulfonic acid groups, carboxylic acid groups, acetoacetyl groups, silanol groups, amino groups and thioalkyl groups and mixtures of two or more of the foregoing groups) and/or alkylene units (preferably selected from ethylene units, propylene units and mixtures thereof) and/or glycol units; preferably a functionalized PVA within this invention in addition to vinyl alcohol and vinyl acetate units only contains one other kind of unit selected from the foregoing. The functionalized PVAs contain the functional groups/alkylene units/glycol units in side chains.

Within the functionalized PVAs those with carboxylic groups in side chains, sulfonic acid groups in side chains and glycol side chains (like those described above with recurring units (a), (b) and (c)) are preferred.

Such functionalized PVAs are commercially available or can be prepared by well known methods, i.e. copolymerization of vinyl acetate with suitable comonomers and subsequent saponification. For example PVAs with COOH groups can be prepared by copolymerization of vinyl acetate and acrylic acid and subsequent saponification of the acetate groups; instead of acrylic acid esters of acrylic acid can be used as these esters are then hydrolyzed together with the vinyl acetate.

In such functionalized PVAs the content of the additional functional groups is preferably 0.1 to 20 mol%; the content of additional alkylene units is preferably 0.1 to 50 mol%, wherein the mol% refers to the content of comonomer used for the preparation of the functionalized PVAs.

The saponification degree of the functionalized PVAs is preferably 70 to 99.9 mol%, more preferably 75 to 99 mol%. The viscosity (4% aqueous solution at 20°C; DIN 53015) of the functionalized PVAs is preferably 2.5 to 50 mPa·s, more preferably 3 to 15 mPa·s. More preferably the functionalized PVAs show a saponification degree of 70 to 99.9 mol% (even more preferred 75 to 99 mol%) and a viscosity (4% aqueous solution at 20°C; DIN 53015) of 2.5 to 50 mPa·s (even more preferred 3 to 15 mPa·s).

By means of the molecular weight of the used polyvinyl alcohols, adhesion and water-solubility of the overcoats can be controlled. A lower molecular weight (corresponding to a lower viscosity) promotes the removal of the overcoat with aqueous solutions.

The water-soluble overcoats can be applied by means of surface coating methods known to the skilled practician such as doctor blade coating, roller coating, slot coating, curtain coating, spray or dipping processes. Dry layer weights of from 0.05 to 10 g/m$^2$, more preferably 0.2 to 5 g/m$^2$, even more preferably 0.3 to 3 g/m$^2$ are suitable; according to a most preferred aspect the overcoat has a dry layer weight of 0.3 to 1 g/m$^2$.

In many cases it is favorable to apply the water-soluble overcoats in an aqueous solution. This has the least detrimental effects on the environment and the human body.

For some applications, however, it can also be favorable to use organic solvents. In some cases the addition of 0.5 to 60 wt-% of an organic solvent to the aqueous coating solution improves adhesion. By means of a slight solvation

of the surface to be overcoated, the adhesive effect of the polymers of the overcoats according to the present invention is increased further. Such additives to solvents can e. g. be alcohols or ketones.

For a uniform and rapid wetting of the surface to be coated, anionic, cationic or non-ionic surfactants may be added to the overcoat coating solutions. The overcoat furthermore can comprise biocides, stabilizers, preservatives, dyeing agents, foam separators and rheological additives. It is also possible to add inorganic or organic particles to the overcoat coating solution as they can improve for instance scratch resistance of the surface; suitable particles are for instance described in US 5,563,023, US 2011/0053085, US 8,105,751 and particularly in US Serial No. 13/482,151. Preferred optional components of the overcoat composition are selected from surfactants, biocides, particles as described in US 13/482,151 and mixtures of the foregoing.

Any aspect or preferred aspect of the overcoat can be combined with any aspect or preferred aspect described above for the substrate and/or sensitizer and/or coinitiator and/or free radical polymerizable component and/or optional binder.

*Content of Alkali Metals and Alkaline-Earth Metals*

The present inventors have found that the shelflife of negative working radiation-sensitive elements comprising an oxygen-barrier layer comprising a polyvinyl alcohol can be improved if the content of alkali metal ions and alkaline-earth metal ions in the coating of the elements in particular the overcoat is limited. In particular the shelflife of elements with onium initiator and an overcoat comprising PVA can be improved.

Within the present invention the expression "alkali metals" refers to Li, Na, K, and Rb, and the expression "alkaline-earth metals" refers to Mg, Ca, Sr, and Ba.

In accordance with the present invention the total content of alkali metal and alkaline-earth metal has to be limited to a value equal to or below 0.5 $mg/m^2$ radiation-sensitive element, preferably $\leq$0.3 $mg/m^2$ plate when normalized to a dry layer weight of 1 $g/m^2$ of coating material removable in 60s at 22°C by soaking in deionized water. Most preferred the sodium content is $\leq$0.2 mg $Na/m^2$ plate and the content of each of Li, K, Rb, Mg, Ca, Sr, and Ba is $\leq$ 0.0002 $mg/m^2$ plate, again when normalized to a dry layer weight of 1 $g/m^2$ of removable coating material.

When reference is made to the content of alkali metals and alkaline-earth metals within this invention it is referred to the content obtained by the following method:

> A sample (e.g. a sample of 1 $dm^2$) of an imageable element with radiation-sensitive coating and overcoat is subjected to soaking in deionized water (the amount of water is such that the sample is totally covered by water) at 22°C for 60s (which is sufficient for totally dissolving and therefore removing the overcoat from the imageable element) and then the content of Li, Na, K, Rb, Mg, Ca, Sr and Ba in mg in the wash water is determined by ICP-OES (Inductively coupled plasma optical emission spectrometry). The values are corrected by the amounts of alkali and alkaline-earth metals present in a control sample (i.e. same amount of deionized water as used for the soaking). By taking into account the size of the washed sample of the element (e.g. 1 $dm^2$; in such a case the amount of wash water may be for instance 25 ml) the content of the alkali metals and alkaline-earth metals can be expressed as $mg/m^2$ radiation-sensitive element and it can further be normalized to a dry layer weight of 1 $g/m^2$ of the removed coating material; the dry layer weight can be easily determined from the weight of the sample of the imageable element before and after washing (usually the soaking at 22°C for 60s completely removes the overcoat but does not substantially remove the imageable coating so that the amount is usually normalized to a dry layer weight of 1 $g/m^2$ of the overcoat).

In other words, the total content of alkali metals and alkaline earth metals in mg per 1 $m^2$ imageable element, normalized to 1 $g/m^2$ removed material is calculated by

$$(A_s\text{-}A_c) : (W_b\text{-}W_a)$$

wherein

- $A_s$ = total amount of alkali metals and alkaline earth metals in mg determined for a sample of imageable element with z $m^2$
- $A_c$ = total amount of alkali metals and alkaline earth metals in mg determined for the water used for soaking (same ml as used for the soaking of the sample of z $m^2$)
- $W_b$ = dry weight of the sample of the imageable element (sample size z $m^2$) before soaking
- $W_a$ = dry weight of the plate sample of the imageable element (sample size z $m^2$) after soaking.

It is understood by those skilled in the art that the alkali metals and alkaline-earth metals measured by the above analytical process are not present in the coatings in metallic form but as metal ions.

In order to meet the requirement of the low content of alkali metal and alkaline-earth metals the components (including optional components) used should be selected such that alkali metal ions and alkaline-earth metal ions as counterions are avoided or the amount of such components is restricted.

It is also or in addition possible to subject the coating solution for the radiation-sensitive coating and/or for the overcoat (preferably for the overcoat) to a treatment with a cation-exchanger in order to reduce the amount of alkali metal ions and alkaline-earth metal ions.

It is important to not only think about any alkali or alkaline-earth metal ions of the desired components used for the coating compositions but to also take into account any possible contamination of desired components used for the coating compositions. In this connection reference is for instance made to the above-mentioned large-scale processes for producing PVA and the sodium acetate being present in commercially available PVAs. The present inventors have found that commercial PVAs usually have a sodium content expressed as $Na_2O$ ash of 0.09 to 2 wt% (resulting in Na contents of about 0.334 to about 7.42 mg/$m^2$ plate when normalized to an overcoat consisting of PVA with a dry layer weight of 1 g/$m^2$) which has a negative effect on the shelflife of the negative working radiation-sensitive elements. It is therefore preferred that either the coating solution for the overcoat before coating or an aqueous solution of the PVA used for the overcoat prior to the preparation of the coating solution for the overcoat is subjected to a treatment with a cation-exchanger in order to reduce the content of alkali metal ions and alkaline-earth metal ions (in particular the content of sodium ions) in the overcoat coating solution (and consequently in the dried overcoat).

For this treatment common cation-exchanger resins can be used, e.g. those with a polystyrene matrix, a styrene-copolymer matrix, or a polyacrylic matrix. Cation-exchange resins with a formaldehyde matrix, a cellulose based matrix or a dextran based matrix may also be used but are less preferred.

Cation-exchange resins can be separated into 2 classes according to their active groups:

(1) strongly acidic
(2) weakly acidic

Strongly acidic cation-exchangers for instance contain $-SO_3H$ groups, $-O-C_2H_4-SO_3H$, $-(CH_2)_3-SO_3H$, or $-O-PO_3H_2$ groups, with $-SO_3H$ groups being preferred.
Weakly acidic cation-exchangers for instance contain -COOH groups, or $-O-CH_2-COOH$ groups, with -COOH groups being preferred.

Widely used cation-exchangers are styrene-divinyl benzene copolymer matrices with $-SO_3H$ groups (strongly acidic), polyacrylic acid (weakly acidic) or copolymers of acrylic acid, styrene and divinyl benzene (weakly acidic).

Suitable cation-exchangers are commercially available and usually are in the form of pearls with a diameter of 0.1 to 2 mm. It is well known to those skilled in the art that a commercial ion exchanger - before using it - has to be converted in its acid form if the obtained commercial product is in the salt form. Suitable methods therefore are known to those skilled in the art.

If an aqueous solution of a PVA is treated with a cation-exchanger (in its acid form) the amount of cation-exchanger is preferably 1g per 5 to 50 g preferably 1g per 10 to 20 g solid PVA.

The cation-exchange resin can simply be added to the solution and then stirred, preferably for 5 to 30 minutes. Thereafter, the exchange resin is filtered off and the obtained treated solution can then be directly applied to the radiation-sensitive coating if (1) the overcoat coating solution was treated or (2) the overcoat should consist of PVA, or the obtained solution is used for the preparation of the overcoat coating solution (if a solution of the PVA was used and an overcoat containing other components in addition to PVA is desired) without any further step.

Instead of this discontinuous treatment also a continuous treatment by using a column packed with cation-exchange resin can be carried out.

The cation-exchange resin should be selected such that the total capacity (in equivalent/kg) thereof is higher than the expected total equivalent content of alkali and alkaline-earth metals; preferably total capacity = X · expected total equivalent content with X being at least 2, e.g. 3 to 5.

While the sole treatment with an anion-exchanger was found to have no improving effect on the shelflife of the imageable elements sometimes the combined treatment (i.e. cation exchanger plus anion exchanger) was found to result in a small improvement compared to cation-exchanger alone. In case of such a combined treatment the treatment with anion exchanger and the treatment with cation exchanger can take place simultaneously or sequentially; in case of sequential treatment it can be in any order (preferably the treatment with cation exchanger takes place first followed by the treatment with anion-exchanger). As anion-exchange resins e.g. polystyrene materials with amine groups (weakly basic) or quaternary ammonium groups (strongly basic) or polyacrylic resins with amine/ammonium groups can be used; strongly basic anion-exchangers are preferred.

It is also possible to treat the coating solution for the radiation-sensitive layer with a cation-exchanger (and

optionally with an anion-exchanger). In case of essential cations in the coating solution (e.g. onium compounds as coinitiator and/or cationic cyanine sensitizers) may, however, also reduce the content of the desired cations; in such a case the treatment of desired single components for the radiation sensitive layer (e.g. the binder) instead of treating the coating solution for the radiation-sensitive layer is preferred.

The treatment with the ion exchanger is easily carried out and the used ion exchanger can be reused (if necessary after regeneration by commonly known methods).

*IMAGEWISE EXPOSURE*

If the sensitizer component used in the photopolymerizable coating absorbs UV/VIS radiation of a wavelength of 300 to 750 nm (and preferably shows an absorption maximum in this range), the precursors are imagewise exposed in a manner known to the person skilled in the art with UV/VIS radiation of a wavelength of 300 to 750 nm. For this purpose, common lamps, such as carbon arc lamps, mercury lamps, xenon lamps and metal halide lamps, or lasers or laser diodes can be used. UV laser diodes emitting UV radiation in the range of about 405 nm (e.g. 405 ± 10 nm), argon ion lasers emitting in the visible range (488 nm or 514 nm) and frequency-doubled fd:Nd:YAG lasers emitting at around 532 nm are of particular interest as a radiation source. The laser radiation can be digitally controlled via a computer, i.e. it can be turned on or off so that an imagewise exposure of the plates can be effected via stored digitized information in the computer; this way, so-called computer-to-plate (ctp) printing plates can be obtained.

If the absorber component absorbs IR radiation, i.e. noticeably absorbs radiation of a wavelength in the range of more than 750 to 1,200 nm, and preferably shows an absorption maximum in this range in its absorption spectrum, imagewise exposure can be carried out with IR radiation sources. Suitable radiation sources are e.g. semi-conductor lasers or laser diodes which emit in the range of more than 750 to 1200 nm, for example Nd:YAG lasers (1,064 nm), laser diodes which emit between 790 and 990 nm (e.g. 830 nm), and Ti:sapphire lasers. The laser radiation can be digitally controlled via a computer, i.e. it can be turned on or off so that an imagewise exposure of the plates can be effected via stored digitized information in the computer; this way, so-called computer-to-plate (ctp) printing plates can be obtained. Any image-setters equipped with IR lasers that are known to the person skilled in the art can be used.

The imagewise exposed precursor comprises exposed and unexposed areas of the coating.

To strengthen the image the exposed plate precursor can be optionally heated to 60 to 150°C in a separate oven or in a unit being part of a processor to develop the plate.

*PROCESSING OF THE EXPOSED PRECURSOR*

After imagewise exposure the precursor is treated with a developer in order to remove the coating in the non-image (i.e. non-exposed) areas thereby revealing the substrate in said areas. The overcoat can be removed by washing/rinsing with water before applying the developer. According to one embodiment the overcoat is not removed in a separate step but is removed together with the non-image areas of the radiation sensitive coating in a single step by treating the exposed precursor with a suitably selected developer.

After removing the non-image areas of the coating and the overcoat with the developer, the treated precursor can optionally be dried.

According to another embodiment after removing the non-image areas of the coating and the overcoat with the developer, the treated precursor can be rinsed with water.

According to a further embodiment after removing the non-image areas of the coating and the overcoat with the developer and rinsing the precursor with water it is possible to apply a hydrophilic finishing gum.

According to one embodiment ("single-step-processing") treating an exposed precursor with a developer results in (1) removing of the overcoat in the exposed and unexposed areas (if the overcoat was not removed before the treatment with the developer), (2) removing of the non-image areas of the radiation sensitive coating, and (3) providing of a protective gumming in one single step provided that the developer is selected accordingly.

Typically, the exposed precursor is contacted with the developer by rubbing or wiping the imageable layer with an applicator containing this liquid. Alternatively, the exposed precursor may be brushed with the developer or the developer may be applied to the precursor by spraying. The treatment with the developer can also be carried out by immersing the exposed precursor in a bath of the developer. According to one embodiment, the processing may be carried out in a commercially available processor, such as TDP 60 (Horsell) which contains only one bath for the developer and a drying section. Additionally, a conductivity-measuring unit can be incorporated into the processor.

According to another embodiment, conventional processors equipped with an immersion type developing bath, a section for rinsing with water, a gumming section, and a drying section, can be used. Additionally, a conductivity-measuring unit can be incorporated into the processor for controlling the developer activity of the developer.

The exposed precursor is typically treated with the developer at a temperature of about 18°C to about 28°C, for a period of about 5 seconds to about 60 seconds.

After a certain number of exposed precursors have been processed, the developing activity (for instance measured by titration or conductivity measurement) of a developer bath falls below a predetermined level. Then fresh developer is added to the bath (also called "top-up" process). Usually about 10 mL to about 200 mL, typically about 20 -120 mL, of fresh developer per 1 $m^2$ of precursor processed is necessary to keep both the volume of developer and its activity/conductivity value constant. The processed element, e.g. lithographic printing plate comprises regions in which the imageable layer has been removed revealing the underlying surface of the hydrophilic substrate, and complimentary regions in which the imageable layer has not been removed. The regions in which the imageable layer has not been removed are ink receptive.

Instead of adding fresh developer for keeping the activity of the developer bath constant a regenerator can be added. The regenerator suitably differs from the fresh developer in that the concentration of the alkaline reagent is higher compared to the concentration of the alkaline reagent in the fresh developer used; the concentration of the other components might be the same or higher as in the fresh developer.

After having contacted the element with the developer any excess of said developer remaining on the element is removed (for instance by means of squeeze rollers; washing/rinsing the precursor with a liquid like water etc). After a subsequent optional drying step the processed element can be transferred to a press if the element is a lithographic printing plate. On the press the lithographic printing plate is contacted with fountain solution and printing ink, either simultaneously or subsequently (in any order, but preferably first fountain solution and thereafter ink). By contacting the precursor with the fountain solution and ink and thereafter with paper any remainders of undesired coating (radiation-sensitive coating in the non-image areas and/or overcoat) which have not already been removed by the treatment with the developer are removed.

*Developer*

The developer used in the method of the present invention for developing the radiation-sensitive elements of the present invention as described above is an aqueous solution having a pH value of >5, preferably a pH of from 7.5 to 13.5, more preferably a pH of from 8 to 12.

*Water*

Tap water, deionized water or distilled water can be used. The amount of water is preferably in the range of 45 to 98 wt-%, based on the total weight of the developer, especially preferred 50 to 95 wt-% and particularly preferred 80 to 95 wt-%.

*Alkaline component*

The developer used in the present invention may comprise an organic or inorganic alkaline component.

The alkaline component can for instance be selected from alkali silicates, alkali hydroxides, $Na_3PO_4$, $K_3PO_4$, $Na_2CO_3$, amino acids, alkali or earth alkali borates, $NR_4OH$, wherein each R is independently selected from $C_1$-$C_4$ alkyl groups and $C_1$-$C_4$ hydroxyalkyl groups, amines and mixtures of 2 or more of the foregoing.

The amount of the alkaline component, or in case of mixtures the total amount of the alkaline components, is preferably selected such that the pH value of the developer is >5 to 14, preferably, the pH is in the range of 7.5 to 13.5, more preferably in the range of 8 to 12.

As used in the present invention, the term "alkali silicates" also encompasses metasilicates and water glasses. Sodium silicates and potassium silicates are preferred silicates. When alkali silicates are used, the amount of silicate is preferably at least 1 wt-% (calculated as $SiO_2$), based on the developer.

Of the alkali hydroxides, NaOH and KOH are especially preferred.

Usually the use of alkali metasilicates readily provides a pH value of more than 12 without further alkaline additives such as e.g. alkali hydroxide. When water glass is used, an alkali hydroxide is used in addition if a pH value of more than 12 is desired.

Preferred quaternary ammonium hydroxides $NR_4OH$ include for example tetramethyl ammonium hydroxide, trimethylethanol ammonium hydroxide, methyltriethanol ammonium hydroxide and mixtures thereof; an especially preferred ammonium hydroxide is tetramethyl ammonium hydroxide.

Suitable amines are primary, secondary and tertiary amines. Examples are mono-, di-, and trialkanol amines like monoethanol amine, diethanol amine, triethanolamine, (2-aminoethoxy)ethanol, 2-amino-2-methyl-1-propanol, 1-aminopropanol, diisopropanol amine, 2-(methylamino) ethanol, and triisopropanol amine. Monoethanol amine, diethanol amine, triethanolamine are most preferred.

The preferred alkaline compound is an amine as defined above.

*Surfactant*

An optional component of the developer used in the present invention is the surfactant.

The surfactant is not specifically limited as long as it is compatible with the other components of the developer and soluble in aqueous alkaline solutions with a pH of >5. The surfactant can be a cationic, an anionic, an amphoteric or a nonionic one or a mixture of two or more thereof.

Examples of anionic surfactants include hydroxyalkanesulfonates, alkylsulfonates, dialkyl-sulfosuccinates, straight-chain alkylbenzenesulfonates, branched alkylbenzenesulfonates, alkylnaphthalenesulfonates, alkylphenoxypolyoxyethylenepropylsulfonates, salts of polyoxyethylene alkylsulfophenyl ethers, sodium N-methyl-N-oleyltaurates, monoamide disodium N-alkylsulfosuccinates, petroleum sulfonates, sulfated castor oil, sulfated tallow oil, salts of sulfuric esters of aliphatic alkylesters, salts of alkylsulfuric esters, sulfuric esters of polyoxyethylenealkylethers, salts of sulfuric esters of aliphatic monoglycerides, salts of sulfuric esters of polyoxyethylenealkylphenylethers, salts of sulfuric esters of polyoxyethylenestyrylphenylethers, salts of alkylphosphoric esters, salts of phosphoric esters of polyoxyethylenealkylethers, salts of phosphoric esters of polyoxyethylenealkylphenylethers, partially saponified compounds of styrenemaleic anhydride copolymers, partially saponified compounds of olefin-maleic anhydride copolymers, naphthalenesulfonateformalin condensates, sodium dodecylphenoxybenzene disulfonates, the sodium salts of alkylated naphthalenesulfonate, disodium methylene-dinaphtalene-disulfonate, sodium dodecyl-benzenesulfonate, (di)sulfonated alkyldiphenyloxides, ammonium or potassium perfluoroalkylsulfonates and sodium dioctyl-sulfosuccinate.

Particularly preferred among these anionic surfactants are alkylnaphthalenesulfonates, disulfonated alkyldiphenyloxides, and alkylsulfonates.

Suitable examples of the nonionic surfactants include polyoxyethylene alkyl ethers, polyoxyethylene phenyl ethers, polyoxyethylene 2-naphthyl ethers, polyoxyethylene alkyl phenyl ethers, polyoxyethylene polystyryl phenyl ethers, polyoxyethylene polyoxypropylene alkyl ethers, polyoxyethylene polyoxypropylene block polymers, partial esters of glycerinaliphatic acids, partial esters of sorbitanaliphatic acid, partial esters of pentaerythritolaliphatic acid, propyleneglycolmonoaliphatic esters, partial esters of sucrosealiphatic acids, partial esters of polyoxyethylenesorbitanaliphatic acid, partial esters of polyoxyethylenesorbitolaliphatic acids, polyethyleneglycolaliphatic esters, partial esters of poly-glycerinaliphatic acids, polyoxyethylenated castor oils, partial esters of polyoxyethyleneglycerinaliphatic acids, aliphatic diethanolamides, N,N-bis-2-hydroxyalkylamines, polyoxyethylene alkylamines, triethanolamine aliphatic esters, alkoxylated aromatic compounds and trialkylamine oxides. Particularly preferred among these nonionic surfactants are alkoxylated aromatic compounds like polyoxyethylene phenyl ethers, polyoxyethylene-2-naphthyl ethers as disclosed in EP 1172699, polyoxyethylene di-styryl phenyl ether and polyoxyethylene tri-styryl phenyl ether as disclosed in EP 1722275.

Further, fluorine containing and silicone anionic and nonionic surfactants may be similarly used.

Amphoteric surfactants are for example N-alkylamino acid triethanol ammonium salts, cocamidopropyl betaines, cocamidoalkyl glycinates, sodium salt of a short chain alkylaminocarboxylate, N-2-hydroxyethyl-N-2-carboxyethyl fatty acid amidoethylamin sodium salts, and carboxylic acid amidoetherpropionates; preferred are cocamidopropylbetaines.

Examples of cationic surfactants are tetraalkyl ammoniumchlorides like tetrabutyl ammoniumchloride and tetramethyl ammoniumchloride, and polypropoxylated quaternary ammonium chlorides.

Nonionic, anionic and amphoteric surfactants as well as mixtures thereof are preferred.

It is preferred that the developer used in the present invention comprises at least one member selected from surfactants and alkaline components.

Two or more of the above surfactants may be used in combination. The amount of the surfactant (or total amount of surfactants if more than one is used) is not specifically limited but is preferably from 0.01 to 20 wt-%, more preferably from 2 to 8 wt-% based on the total weight of the developer.

*Water-soluble film forming hydrophilic polymer*

One optional component of the developer is a water-soluble film forming hydrophilic polymer. The use of such a polymer is especially suitable if a "single step processing" (i.e. developing and gumming in one process step) is desired.

Examples of suitable polymers are gum arabic, pullulan, cellulose derivatives such as hydroxymethyl celluloses, carboxymethylcelluloses, carboxyethylcelluloses or methyl-celluloses, starch derivatives like (cyclo)dextrins, poly(vinyl alcohol), poly(vinyl pyrrolidone), polyhydroxy compounds like polysaccharides, homo- and copolymers of acrylic acid, methacrylic acid or acrylamide, a copolymer of vinyl methyl ether and maleic anhydride, a copolymer of vinyl acetate and maleic anhydride or a copolymer of styrene and maleic anhydride. Preferred polymers are homo- or copolymers of monomers containing carboxylic, sulfonic or phosphonic groups or the salts thereof, e.g. (meth)acrylic acid, vinyl acetate, styrene sulfonic acid, vinyl sulfonic acid, vinyl phosphonic acid and acrylamidopropane sulfonic acid, polyhydroxy compounds and starch derivatives.

Polyhydroxy compounds and starch derivatives are especially preferred. The starch derivative should be water-soluble, preferably cold-water-soluble and is selected from starch hydrolysis products such as dextrins and cyclodextrins,

starch esters, such as phosphate esters and carbamate esters, starch ethers, such as e.g. cationic starch ethers and hydroxypropyl ethers, carboxymethyl starch and acetylated starch; from the above derivatives dextrins (including dextrin comprising sodium tetraborate and available as borax dextrin from Emsland Stärke GmbH) are preferred.

The starch used as a starting product for the starch derivatives can be of various origins, it can e.g. be obtained from corn, potatoes, rye, wheat, rice, manioc, tapioca, chestnuts or acorns; corn starch and potato starch are preferred.

Suitable water-soluble polyhydroxy compounds can be represented by the following structure:

$$R^1(CHOH)_nR^2$$

in which n is 4 to 7; and

either (i) $R^1$ is hydrogen, aryl, or $CH_2OH$; and $R^2$ is hydrogen, an alkyl group having 1 to 4 carbon atoms, $CH_2OR^3$ in which $R^3$ is hydrogen or an alkyl group having 1 to 4 carbon atoms, $CH_2N(R^4R^5)$ in which $R^4$ and $R^5$ are each independently hydrogen or an alkyl group having 1 to 4 carbon atoms, or $CO_2H$,

or (ii) $R^1$ and $R^2$ together form a carbon-carbon single bond.

In one group of polyhydroxy compounds, $R^1$ is hydrogen or $CH_2OH$ and $R^2$ is hydrogen. In a preferred group of these polyhydroxy compounds, n is 5 or 6. This group includes the sugar alcohols, compounds of the structure $H(CHOH)_nH$, which do not carry a free aldehyde or ketone group and do not show a reducing property. The sugar alcohols may be obtained from natural sources or prepared by hydrogenation of reducing sugars. Preferred sugar alcohols include mannitol, sorbitol, xylitol, ribitol, and arabitol. Other sugar alcohols include, for example, talitol, dulcitol, and allodulcitol.

In another group of polyhydroxy compounds, $R^1$ and $R^2$ together form a carbon-carbon single bond. Included are carbocyclic compounds of the structure: $(CHOH)_n$, in which n is 4 to 7. In a preferred group of these polyhydroxy compounds, n is 5 or 6, more preferably 6. There are nine possible stereoisomers of 1,2,3,4,5,6-hexahydroxycyclohexane, several of which are naturally occurring. A preferred polyhydroxy compound is meso-inosit (cis-1,2,3,5-trans-4,6-hexahydroxycyclohexane). meso-Inosit can be isolated from corn steep liquor.

In another group of polyhydroxy compounds, $R^1$ is hydrogen, aryl, or $CH_2OH$; and $R^2$ is an alkyl group having 1 to 4 carbon atoms, $CH_2OR^3$ in which $R^3$ is an alkyl group having 1 to 4 carbon atoms, $CH_2N(R^4R^5)$ in which $R^4$ and $R^5$ are each independently H or an alkyl group having 1 to 4 carbon atoms, or $CO_2H$.

In another group of polyhydroxy compounds, $R^1$ is hydrogen or $CH_2OH$; and $R^2$ is $CO_2H$. More preferably, $R^1$ is H and n is 4 or 5. This group includes polyhydroxy compounds of the structure $H(CHOH)_nCO_2H$, in which n is 4 or 5. Conceptually, these polyhydroxy compounds may be produced by oxidation of the corresponding hexose or pentose sugar, i.e., oxidation of the aldehyde group of a hexose sugar such as glucose, galactose, allose, mannose, etc., or oxidation of the aldehyde of a pentose sugar such as arabinose, ribose, xylose, etc.

Particularly preferred polyhydroxy compounds are the sugar alcohols mentioned above, like sorbitol.

The amount of the film forming polymer is not specifically limited; preferably - if present at all - it is from 1 to 30 wt-% based on the total weight of the developer, more preferably from 5 to 20 wt-%.

*Further optional components of the developer*

Besides the essential components and the above-cited optional components the developer used in the present invention may contain further additives like organic solvents, biocides, complexing agents, buffer substances, dyes, antifoaming agents, odorants, anticorrosive agents and radical inhibitors.

Antifoaming agents:

Suitable antifoaming agents include e.g. the commercially available Silicone Antifoam Emulsion SE57 (Wacker), TRITON® CF32 (Rohm & Haas), AKYPO® LF (ethercarboxylic acid Chem Y), Agitan 190 (Münzing Chemie), TEGO® Foamese 825 (modified polysiloxane, TEGO Chemie Service GmbH, Germany). Silicone-based antifoaming agents are preferred. They are either dispersible or soluble in water. The amount of antifoaming agent in the developer is preferably 0 to 1 wt-%, based on the weight of the developer especially preferred 0.01 to 0.5 wt-%. One antifoaming agent or a mixture of two or more can be used.

Buffers:

Suitable buffer substances include e.g. tris(hydroxymethyl)-aminomethane (TRIS), hydrogen phosphates, glycine, 3-(cyclohexylamino)-propane sulfonic acid (CAPS), hydrogen carbonates, borates including borax, 2-amino-2-methyl-1-propanol (AMP), 3-(cyclohexylamino)-2-hydroxy-1-propane-sulfonic acid (CAPSO), and 2-(N-cyclohexylamino)ethan-sulfonic acid (CHES).

Biocides:

The biocides should be effective against bacteria, fungi and/or yeasts. Suitable biocides include e.g. N-methylol-chloroacetamide, benzoic acid, p-hydroxybenzoic acid esters, phenol or its derivatives, formalin, imidazol derivatives, isothiazolinone derivatives like 1,2-benziso-thiazolin-3-on, benzotriazole derivatives, amidines, guanidine derivatives, quaternary ammonium salts, pyridine, quinoline derivatives, diazine, triazole derivatives, oxazole and oxazine derivatives and mixtures thereof. Their amount is not particularly restricted and preferably accounts for 0 to 10 wt-% in the developer, based on the total weight of the solution, especially preferred 0.1 to 1 wt-%. One biocide or a mixture of two or more can be used.

Complexing agents:

Examples of suitable complexing agents include: Aminopolycarboxylic acid and salts thereof, such as ethylene diamine tetraacetic acid and potassium or sodium salts thereof, diethylene triamine pentaacetic acid and potassium or sodium salts thereof, triethylene tetraaminohexaacetic acid and potassium or sodium salts thereof, hydroxyethyl ethylene diamine triacetic acid and potassium or sodium salts thereof, nitrilotriacetic acid and potassium or sodium salts thereof, 1,2-diaminocyclohexane-tetraacetic acid and potassium or sodium salts thereof and 1,3-diamino-2-propanol-tetraacetic acid and potassium or sodium salts thereof, and an organophosphonic acid, phosphonoalkane tricarboxylic acid or salts thereof, such as 2-phosphono-butane-1,2,4-tricarboxylic acid and potassium or sodium salts thereof, phosphonobutane-2,3,4-tricarboxylic acid and potassium or sodium salts thereof, phosphonoethane-2,2,2-tricarboxylic acid and potassium or sodium salts thereof, aminotris-(methylene-phosphonic acid) and potassium or sodium salts thereof and sodium gluconate. The complexing agents can be used individually or as a combination of two or more. Organic amine salts of the above-mentioned complexing agents can be used instead of the potassium or sodium salts thereof. The amount of complexing agent preferably accounts for 0 to 5 wt-% in the developer, based on the total weight of the solution, especially preferred 0.01 to 1 wt-%.

Solvents:

The developer may also comprise an organic solvent or a mixture of organic solvents. The developer is a single phase. Consequently, the organic solvent must be miscible with water, or at least soluble in the developer to the extent it is added to the developer, so that phase separation does not occur. The following solvents and mixtures of these solvents are suitable for use in the developer: the reaction products of phenol with ethylene oxide and propylene oxide, such as ethylene glycol phenyl ether; benzyl alcohol; esters of ethylene glycol and of propylene glycol with acids having six or fewer carbon atoms, and ethers of ethylene glycol, diethylene glycol, and of propylene glycol with alkyl groups having six or fewer carbon atoms, such as 2-ethylethanol and 2-butoxyethanol. A single organic solvent or a mixture of organic solvents can be used. The organic solvent is typically present in the developer at a concentration of between about 0 wt-% to about 15 wt-%, based on the weight of the developer preferably between about 3 wt-% and about 5 wt-%, based on the weight of the developer.

Anticorrosive agents:

Examples of anticorrosive agents are phosphonic acids and their salts like hydroxyethyl phosphonic acid and its salts, amino trismethylene phosphonic acid and its salts, and diethylentriaminpentamethylene phosphonic acid and its salts; phosphates like trisodium phosphate; borates like borax; as well as glycerol and glycols having the formula

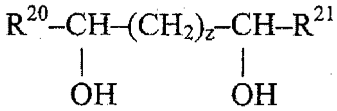

(wherein z is 0, 1 or 2 and $R^{20}$ and $R^{21}$ are independently hydrogen or $C_1$-$C_3$ alkyl).

The anticorrosive agent or mixture of such agents is typically present in the developer at a concentration of about 0 to 10 wt-% based on the weight of the developer, preferably 0.1 to 5 wt-%, in case of glycerol or a glycol 5 to 10 wt-%.

Further additives:

Odorants and dyes can also be present in the developer, if desired. The dyes are added in order to prevent confusion at the users when different processing chemicals like developer and replenisher are used parallel at the same user. Examples for classes of dyes that can be used are azo dyes, triarylmethan dyes or phthalocyanines. The concentration of the dyes in the developer is typically 0.0005 to 0.5 wt.-%.

Odorants are used in order to compensate unpleasant smell of other components in the developer. The typical concentration of odorants is within 0.001 to 1 wt..-%.

The present invention is described in more details in the following examples; however they are not intended to restrict the invention in any way.

**Examples**

The following components were used when preparing the imageable elements used in the Examples:

| | |
|---|---|
| Binder 1 | copolymer of 20mol-% methacrylic acid, 40 mol-% allyl methacrylate, 20 mol-% benzyl methacrylate and 20 mol-% N-isopropyl methacrylamide |
| Hydridur 580 | polymer dispersion (40 % in water) of anionically stabilized urethane-acrylic hybride polymers available from Air Products |
| Initiator 1 | 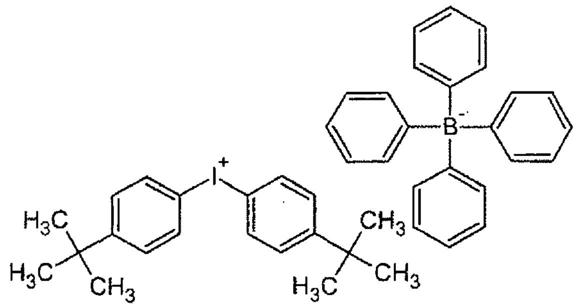 |
| Ion exchange resin Type 1 | weak acidic cation exchange resin, Amberlite IRC-86 from FLUKA |
| Ion exchange resin Type 2 | strong acidic cation exchange resin, Lewatit K-2629 from FLUKA |
| Ion exchange resin Type 3 | weak basic anion exchange resin, Amberlyst A21 from ALDRICH |
| Monomer 1 | dipentaerythritol pentaacrylate available from Sartomer |
| Naxan ABL | alkylated naphthalene sulfonate, sodium salt from Nease Corporation |
| PVA 1 | Poval PVA-403 available from Kuraray, Germany |
| PVA 2 | KL-506, poly(vinyl alcohol) functionalized with carboxylic acid groups having a saponification degree of about 78% from Kuraray, Germany, |
| PVA 3 | Gohseran L-3266, poly(vinyl alcohol) functionalized with sulfonic acid groups having a saponification degree of about 87% from Nippon Gohsei, Japan |
| Pigment 1 | dispersion in propylene glycol monomethyl ether containing 9 wt. % of copper phthalocyanine and 1 wt. % of a poly(vinyl acetal) binder containing 39.9 mol% of vinyl alcohol, 1.2 mol% of vinyl acetate, 15.4 mol% of acetal groups from acetaldehyde, 36.1 mol% of acetal groups from butyraldehyde, and 7.4 acetal groups from 4-formylbenzoic acid |

(continued)

| | |
|---|---|
| Sensitizer 1 | 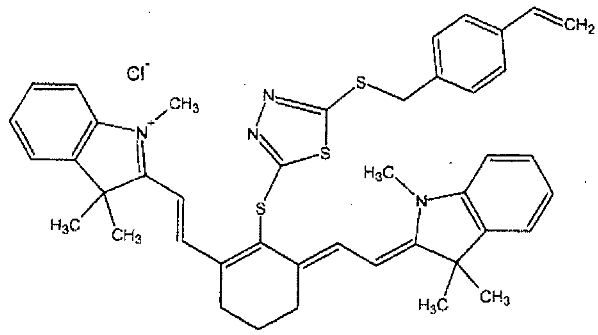 |
| Sorbidex 200 | sorbitol from CG Germany |
| SR9053 | mixture of an ethoxylated trimethylolpropan triacrylate and a trifunctional acidic ester from Sartomer |

**General method for preparing lithographic printing plate precursors**

An electrochemically roughened and anodized aluminum foil with an oxide weight of 3 $g/m^2$ was subjected to an after treatment using an aqueous solution of poly(vinyl phosphoric acid). The average roughness of the surface was 0.55 μm. Imageable layer coating compositions as defined in Table 1 below were applied to the substrate after filtering using a wire bar coater. The coatings were dried for 4 minutes at 90°C to provide a dry coating weight of 1.2 $g/m^2$.

An overcoat solution was prepared corresponding to Table 2 below. To 100g of the overcoat solution 1 g ion exchange resin as described in Table 4 was added. The overcoat solution was stirred with a magnetic stirrer for 15 minutes. The resin pearls were filtered off before using the solution for overcoat application.

The dried imageable layers were overcoated with an aqueous solution as described in Table 2 and Table 4 below using a wire bar coater to provide lithographic printing plate precursors having a dry overcoat weight of 0.5 $g/m^2$ after drying for 4 minutes at 90°C.

**Measurement of the content of alkali and alkaline-earth metals:**

A sample of 1 $dm^2$ was punched out of the precursor. The sample was soaked in 25 ml deionized water p.a. (0.1 μS/cm) at 22°C for 60 s in a Petri dish with the coated side up. The so obtained wash water was analyzed by ICP-OES (inductively coupled plasma optical emission spectrometry) for the content of Li, Na, K, Rb, Mg, Ca, Sr, Ba; the so obtained amount for each metal in mg was corrected by subtraction of the respective amount of the metal in the deionized water (control). By taking into account the sample size of 1 $dm^2$ the obtained values were converted to concentrations in $mg/m^2$ precursor. By subtracting the weight of the dry 1 $dm^2$ sample before and after washing (and subsequent drying for 5 min. at 90°C) the dry weight layer of removed coating material (which is expected to be the overcoat material) can be measured (for the tested examples the obtained dry layer weight of removed material was identical to the dry layer weight of the applied overcoat); the dry weight layer of removed coating material was used for normalizing the obtained values of the metal contents to a dry coating weight of removed material (which was assumed to be the overcoat) of 1 $g/m^2$. For each example and comparative example it was found that sodium is the dominating metal while the other alkali and alkaline-earth metals (i.e. Li, K, Rb, Mg, Ca, Sr, Ba) were only present in very small amounts (the amount of each of them was <1/100 of the amount of sodium).

**Exposure:**

The plates were exposed on a Trendsetter 3244 from Kodak at 830nm. The exposure energy was 70 $mJ/cm^2$.

**Processing Method 1**

The imaged elements (i.e. elements imagewise exposed to radiation) were developed in a processor Kodak Thermal using the following processor settings: developer temperature 23°C, developer Kodak 500 (pH 10.2), regenerator Kodak 550R, regeneration rate 40 $ml/m^2$, post rinse section with water recirculation, gumming section filled with Kodak 850S.

**Processing Method 2**

The imaged plates were processed in a single bath dip tank processor (dwell time of 20sec) having a developing bath equipped with two brushes and a drying unit using air of 65°C. The single bath processor was filled with a gum developer having the composition described in Table 3 and a pH of 10.5.

**Shelflife testing**

For an estimation of the shelflife plates were subjected to an accelerated ageing test in a climate chamber at 40°C and 80% RH without wrapping paper for 2, 5, 7 and 10 days, respectively. After exposure on a Trendsetter 3244 from Kodak at 830nm with an exposure energy of 70 mJ/cm$^2$ the developability of the plates was evaluated by dipping a strip of the plate for different times into a developer (Kodak SP500), followed by rinsing with water and contacting with an ink. The time needed to get a developed surface that does not accept ink is defined as developability.

For further evaluation of the shelflife a plate was developed 30 sec (Kodak SP500) and loaded in a sheet-fed offset printing machine using abrasive ink (Offset S 7184 available from Sun Chemical which contains 10% of calcium carbonate, fountain solution was Boettcher Fount S-3021 available from Boettcher GmbH.). The non-image areas were checked for ink receptivity.

**Sum of the tonal values**

The UGRA/FOGRA Postscript Strip version 2.0 EPS (available from UGRA), which contains different elements for evaluating the quality of the copies, was used for imaging the plates of the Examples and Comparative Examples with Trendsetter 3244 from Kodak at 830nm. The sum of the total values was used as a measure of the photospeed of the developed plates. It is calculated by adding the measured tonal values of 5%, 10%, 20%, 30%, 40%, 50%, 60%, 70%, 80%, 90% and 95% nominal targets at 150 lpi.

The results are summarized in Table 4.

It becomes clear that plates overcoated with solutions having a low sodium content corresponding to the present invention show a faster developability of aged plates compared to the comparative plates with higher sodium content. Plates having a sodium content above 0.2 mg Na/m$^2$ plate (overcoat weight normalized to 1 g/m$^2$) show toning after 10 days ageing whereas overcoated solutions purified with a cation exchange resin do not. Comparative Example 3 demonstrates that treatment with only anion exchange resin do not improve the shelflife. The sum of the tonal values of the fresh plates is not affected by the treatment with the ion exchange resin; all values are the same within the limit of the experiment.

Table 1

| | |
|---|---|
| 16 g | butanone |
| 20 g | propylene glycol monomethyl ether |
| 2 g | water |
| 1.89 g | of Binder 1 |
| 3.61 g | Pigment 1 |
| 6.51 g | Monomer 1 |
| 0.27 g | SR9053 |
| 0.13 g | Sensitizer 1 |
| 0.75 g | Hybridur 580 (40 % in water) |
| 0.39 g | Initiator 1 |

Table 2

| | |
|---|---|
| 800 g | water* |
| 61.3 g | 15% solution of the PVA as described in Table 4 in water |
| * deionized water p.a. with 0.1 μS/cm | |

Table 3

| | |
|---|---|
| water* | 82.62% |
| ethylene glycol phenyl ether | 5.00% |
| tristyrylphenol ethoxylate (EO54) | 5.00% |
| diethanolamine | 2.00% |
| Sorbidex 200 | 5.00% |
| Naxan ABL | 0.38% |
| * deionized water p.a. with 0.1 μS/cm | |

Table 4 Examples for lithographic plates exposed with 830nm

| | Ion exchange resin type | PVA type in the overcoat | Na content in $mg/m^2$ plate[4)] | Processing | Developability (sec) after accelerated ageing at 40°C/80% r.h. | | | | | ink receptivity after 30 sec developing time[2)] | Sum of the tonal values [3)] |
|---|---|---|---|---|---|---|---|---|---|---|---|
| | | | | | 0 days | 2 days | 5 days | 7 days | 10 days | | |
| Invention Example 1 | Type 1 | PVA 1 | 0.1486 | Method 1 | 5 | 5 | 10 | 15 | 20 | no | 565.1 |
| Invention Example 2 | Type 2 | PVA 1 | 0.0744 | Method | 5 | 5 | 7 | 10 | 20 | no | 565.8 |
| Invention Example 3 | Type 2 | PVA 2 | 0.0558 | Method 1 | 5 | 5 | 5 | 10 | 10 | no | 565.2 |
| Invention Example 4 | Type 2 | PVA 3 | 0.0930 | Method 1 | 5 | 5 | 5 | 10 | 10 | no | 564.9 |
| Invention Example 5 | Type 2 | PVA 1 | 0.0744 | Method 2 | 5 | 5 | 10 | 20 | 20 | no | 565.3 |
| Invention Example 6 | Type 2 and Type 3[1)] | PVA1 | 0.0668 | Method 1 | 5 | 5 | 10 | 15 | 20 | no | 565.9 |
| Comparative Example 1 | no | PVA 1 | 2.0438 | Method 1 | 5 | 10 | 20 | 20 | 30 | yes | 565.5 |
| Comparative Example 2 | no | PVA 2 | 3.5302 | Method 1 | 5 | 10 | 20 | 30 | >30 | yes | 564.8 |
| Comparative Example 3 | no | PVA 3 | 2.8614 | Method 1 | 5 | 10 | 15 | 20 | 30 | yes | 563.9 |
| Comparative Example 4 | Type 3 | PVA 1 | 1.5608 | Method 1 | 5 | 10 | 20 | 20 | 30 | yes | 564.7 |
| Comparative Example 5 | no | PVA 1 | 2.0438 | Method 2 | 5 | 10 | 20 | 20 | >30 | yes | 565.9 |

1) 15 min stirring with ion exchange resin Type 2 followed by filtration and addition of exchange resin Type 3 and filtration
2) The test was made with the 10 days accelerated aged plate
3) The measurement was made with the fresh plate
4) The Na content was normalized to a dry layer weight of removed coating material of 1 $g/m^2$. In each example and comparative example the content of each of Li, K, Rb, Mg, Ca, Sr and Ba was lower than 1/100 of the sodium content of the respective example or comparative example

## Claims

1. Negative working radiation-sensitive element comprising

   (a) a substrate,
   (b) a radiation-sensitive coating over the substrate, wherein said layer comprises

      (i) a free radical polymerizable component,
      (ii) a radiation absorbing sensitizer, and
      (iii) a coinitiator which comprises an onium salt selected from diaryliodonium salts, alkoxypyridinium salts, triarylsulfonium salts and diarylalkylsulfonium salts;

   and
   (c) an overcoat as oxygen barrier layer comprising a polyvinyl alcohol, **characterized in that** the total content of alkali metals being Li Na, K, Rb and alkaline-earth metals being Mg, Ca, Sr, Ba in the coating material removed by 60s soaking of a sample of the element in deionized water at 22°C is equal to or below 0.5 mg/$m^2$ radiation-sensitive element when normalized to a dry layer weight of 1 g/$m^2$ of the removed coating material.

2. Element according to claim 1, wherein the radiation absorbing sensitizer (ii) is an IR absorber absorbing radiation of a wavelength of above 750 to 1200 nm.

3. Element according to claim 2, wherein the IR absorber is a cyanine dye.

4. Element according to any one of claims 1 to 3, wherein the coinitiator (iii) comprises an iodonium borate.

5. Element according to any one of claims 1 to 4, wherein the overcoat (c) comprises at least 70 wt.% of a polyvinyl alcohol based on the dry weight of the overcoat.

6. Element according to any one of claims 1 to 5, wherein the total content of alkali metals and alkaline-earth metals is equal to or less than 0.3 mg/$m^2$ radiation sensitive element when normalized to a dry layer weight of the overcoat of 1 g/$m^2$.

7. Element according to any one of claims 1 to 6, wherein the content of sodium is equal or less than 0.2 mg/$m^2$ and the total content of each other alkali and alkaline-earth metal is $\leq$ 0.0002 mg/$m^2$ when normalized to a dry layer weight of the overcoat of 1 g/$m^2$.

8. Element according to any one of claims 1 to 7, wherein the radiation-sensitive coating further comprises at least one member selected from polymeric binders which may optionally contain ethylenically unsaturated moieties, colorants, antioxidants, flow improvers, surfactants, free radical inhibitors, and inert inorganic or organic particles with an average particle size of 1 to 500 nm, and/or wherein the overcoat further comprises at least one member selected from surfactants, biocides and inert inorganic or organic particles with an average particle size of 1 to 500 nm.

9. Process for producing a negative-working radiation-sensitive element as defined in any one of claims 1 to 8, comprising

   (a) providing an optionally pre-treated substrate,
   (b) applying a radiation-sensitive coating composition as defined in any one of claims 1 to 4 and 8 which comprises

      (i) a free radical polymerizable component,
      (ii) a radiation absorbing sensitizer, and
      (ii) a coinitiator which comprises an onium salt selected from diaryliodonium salts, alkoxypyridinium salts, triarylsulfonium salts and diarylalkylsulfonium salts;

   (c) applying an overcoat coating composition comprising an optionally functionalized polyvinyl alcohol,

   **characterized in that** the total content of alkali metals and alkaline-earth metals in the overcoat coating composition is such that the content is equal to or below 0.5 mg/$m^2$ radiation-sensitive element when normalized to a dry layer weight of the overcoat of 1 g/$m^2$.

10. Process according to claim 9, wherein the overcoat coating composition comprises at least 70 wt.% of an optionally functionalized polyvinyl alcohol based on the total solids content of the overcoat coating composition.

11. The process according to claim 9 or 10, further comprising:

treating the overcoat coating composition with a cation exchange resin before applying the overcoat coating composition to the radiation-sensitive coating obtained in step (b) or
treating an aqueous solution of the polyvinyl alcohol with a cation exchange resin before using it for the preparation of the overcoat coating composition which is applied in step (c).

12. Process according to claim 11, wherein the cation exchange resin is a strongly acidic cation exchange resin comprising sulfonic acid groups.

13. The process according to claim 11 or 12, wherein the overcoat coating composition before or after the treatment with the cation exchange resin or simultaneously to that treatment is additionally treated with an anion exchange resin.

14. Process for preparing an imaged lithographic printing plate precursor, comprising

(a) imagewise exposing a lithographic printing plate precursor as defined in any one of claims 1 to 8
(b) removing the non-exposed areas of the coating of the lithographic printing plate precursor with an aqueous developer having a pH from 5 to 14, wherein the developer optionally comprises a film-forming hydrophilic polymer.

## Patentansprüche

1. Negativ arbeitendes strahlungsempfindliches Element, umfassend

(a) ein Substrat,
(b) eine strahlungsempfindliche Beschichtung über dem Substrat, wobei die Schicht

(i) eine radikalisch polymerisierbare Komponente,
(ii) einen strahlungsabsorbierenden Sensibilisator und
(iii) einen Coinitiator, der ein Oniumsalz, ausgewählt aus Diaryliodoniumsalzen, Alkoxypyridiniumsalzen, Triarylsulfoniumsalzen und Diarylalkylsulfoniumsalzen, umfasst;

umfasst,
und
(c) eine Deckschicht als Sauerstoffsperrschicht, die einen Polyvinylalkohol umfasst, **dadurch gekennzeichnet, dass** der Gesamtgehalt an Alkalimetallen, bei denen es sich um Li, Na, K, Rb handelt, und Erdalkalimetallen, bei denen es sich um Mg, Ca, Sr, Ba handelt, in dem Beschichtungsmaterial, das durch 60 s Tränken einer Probe des Elements in entionisiertem Wasser bei 22°C entfernt wird, gleich oder weniger als 0,5 mg/$m^2$ strahlungsempfindliches Element beträgt, wenn auf ein Trockenschichtgewicht von 1 g/$m^2$ des entfernten Beschichtungsmaterials genormt wird.

2. Element nach Anspruch 1, wobei der strahlungsabsorbierende Sensibilisator (ii) ein IR-Absorber ist, der Strahlung mit einer Wellenlänge von über 750 bis 1200 nm absorbiert.

3. Element nach Anspruch 2, wobei der IR-Absorber ein Cyaninfarbstoff ist.

4. Element nach einem der Ansprüche 1 bis 3, wobei der Coinitiator (iii) ein Iodoniumborat umfasst.

5. Element nach einem der Ansprüche 1 bis 4, wobei die Deckschicht (c) mindestens 70 Gew.-% eines Polyvinylalkohols, bezogen auf das Trockengewicht der Deckschicht, umfasst.

6. Element nach einem der Ansprüche 1 bis 5, wobei der Gesamtgehalt an Alkalimetallen und Erdalkalimetallen gleich oder weniger als 0,3 mg/$m^2$ strahlungsempfindliches Element beträgt, wenn auf ein Trockenschichtgewicht der Deckschicht von 1 g/$m^2$ genormt wird.

**7.** Element nach einem der Ansprüche 1 bis 6, wobei der Gehalt an Natrium gleich oder weniger als 0,2 mg/$m^2$ beträgt und der Gesamtgehalt jedes anderen Alkali- und Erdalkalimetalls $\leq$ 0,0002 mg/$m^2$ beträgt, wenn auf ein Trockenschichtgewicht der Deckschicht von 1 g/$m^2$ genormt wird.

**8.** Element nach einem der Ansprüche 1 bis 7, wobei die strahlungsempfindliche Beschichtung weiter mindestens ein Mitglied, ausgewählt aus polymeren Bindemitteln, die gegebenenfalls ethylenisch ungesättigte Einheiten enthalten können, Färbemitteln, Antioxidantien, Fließverbesserern, grenzflächenaktiven Mitteln, Radikalinhibitoren und inerten anorganischen oder organischen Teilchen mit einer mittleren Teilchengröße von 1 bis 500 nm, umfasst und/oder wobei die Deckschicht weiter mindestens ein Mitglied, ausgewählt aus grenzflächenaktiven Mitteln, Bioziden und inerten anorganischen oder organischen Teilchen mit einer mittleren Teilchengröße von 1 bis 500 nm, umfasst.

**9.** Verfahren zur Herstellung eines negativ arbeitenden strahlungsempfindlichen Elements, wie in einem der Ansprüche 1 bis 8 definiert, umfassend

(a) Bereitstellen eines gegebenenfalls vorbehandelten Substrats,
(b) Aufbringen einer strahlungsempfindlichen Beschichtungszusammensetzung, wie in einem der Ansprüche 1 bis 4 und 8 definiert, welche

(i) eine radikalische polymerisierbare Komponente,
(ii) einen strahlungsabsorbierenden Sensibilisator und
(iii) einen Coinitiator, der ein Oniumsalz, ausgewählt aus Diaryliodoniumsalzen, Alkoxypyridiniumsalzen, Triarylsulfoniumsalzen und Diarylalkylsulfoniumsalzen, umfasst;

umfasst,
(c) Aufbringen einer Deckschicht-Beschichtungszusammensetzung, die einen gegebenenfalls funktionalisierten Polyvinylalkohol umfasst,

**dadurch gekennzeichnet, dass** der Gesamtgehalt an Alkalimetallen und Erdalkalimetallen in der Deckschicht-Beschichtungszusammensetzung derart ist, dass der Gehalt gleich oder niedriger als 0,5 mg/$m^2$ strahlungsempfindliches Element ist, wenn auf ein Trockenschichtgewicht der Deckschicht von 1 g/$m^2$ genormt wird.

**10.** Verfahren nach Anspruch 9, wobei die Deckschicht-Beschichtungszusammensetzung mindestens 70 Gew.-% eines gegebenenfalls funktionalisierten Polyvinylalkohols, bezogen auf den Gesamt-Feststoffgehalt der Deckschicht-Beschichtungszusammensetzung, umfasst.

**11.** Das Verfahren nach Anspruch 9 oder 10, weiter umfassend:

Behandeln der Deckschicht-Beschichtungszusammensetzung mit einem Kationenaustauscherharz vor Aufbringen der Deckschicht-Beschichtungszusammensetzung auf die in Schritt (b) erhaltene strahlungsempfindliche Beschichtung
oder
Behandeln einer wässrigen Lösung des Polyvinylalkohols mit einem Kationenaustauscherharz vor dessen Verwendung zur Herstellung der Deckschicht-Beschichtungszusammensetzung, die in Schritt (c) aufgebracht wird.

**12.** Verfahren nach Anspruch 11, wobei das Kationenaustauscherharz ein stark saures Kationenaustauscherharz ist, das Sulfonsäuregruppen umfasst.

**13.** Das Verfahren nach Anspruch 11 oder 12, wobei die Deckschicht-Beschichtungszusammensetzung vor oder nach der Behandlung mit dem Kationenaustauscherharz oder gleichzeitig mit dieser Behandlung zusätzlich mit einem Anionenaustauscherharz behandelt wird.

**14.** Verfahren zur Herstellung eines bebilderten lithographischen Druckplattenvorläufers, umfassend

(a) bildweises Belichten eines lithographischen Druckplattenvorläufers, wie in einem der Ansprüche 1 bis 8 definiert,
(b) Entfernen der nicht-belichteten Bereiche der Beschichtung des lithographischen Druckplattenvorläufers mit einem wässrigen Entwickler mit einem pH von 5 bis 14, wobei der Entwickler gegebenenfalls ein filmbildendes hydrophiles Polymer umfasst.

**Revendications**

1. Élément sensible au rayonnement à travail négatif comprenant :

   (a) un substrat,
   (b) un revêtement sensible au rayonnement sur le substrat, dans lequel ladite couche comprend

      (i) un composant polymérisable par radicaux libres,
      (ii) un sensibilisateur absorbant le rayonnement, et
      (iii) un coinitiateur qui comprend un sel d'onium sélectionné parmi des sels de diaryliodonium, d'alkoxypyridinium, de triarylsulfonium et de diarylalkylsulfonium ;

   et
   (c) une surcouche faisant office de couche barrière d'oxygène comprenant un alcool polyvinylique, **caractérisé en ce que** la teneur totale de métaux alcalins Li, Na, K, Rb et de métaux alcalino-terreux Mg, Ca, Sr, Ba dans le matériau de revêtement enlevé en faisant tremper un échantillon de l'élément pendant 60 s dans de l'eau désionisée à 22 °C est égale ou inférieure à 0,5 mg/m2 d'élément sensible au rayonnement lorsqu'elle est normalisée à un poids sec de couche de 1 g/m2 du matériau de revêtement enlevé.

2. Élément selon la revendication 1, dans lequel le sensibilisateur absorbant le rayonnement (ii) est un absorbeur d'infrarouge absorbant un rayonnement d'une longueur d'onde de plus de 750 nm et jusqu'à 1200 nm.

3. Élément selon la revendication 2, dans lequel l'absorbeur d'infrarouge est un colorant de cyanine.

4. Élément selon l'une quelconque des revendications 1 à 3, dans lequel le coinitiateur (iii) comprend un borate de iodonium.

5. Élément selon l'une quelconque des revendications 1 à 4, dans lequel la surcouche (c) comprend au moins 70 % en poids d'un alcool polyvinylique sur la base du poids sec de la surcouche.

6. Élément selon l'une quelconque des revendications 1 à 5, dans lequel la teneur totale de métaux alcalins et de métaux alcalino-terreux est égale ou inférieure à 0,3 $mg/m^2$ d'élément sensible au rayonnement lorsqu'elle est normalisée à un poids sec de couche de la surcouche de 1 $g/m^2$.

7. Élément selon l'une quelconque des revendications 1 à 6, dans lequel la teneur de sodium est égale ou inférieure à 0,2 $mg/m^2$ et la teneur totale de chaque autre métal alcalin et métal alcalino-terreux est $\leq$0,0002 $mg/m^2$ lorsqu'elle est normalisée à un poids sec de couche de la surcouche de 1 $g/m^2$.

8. Élément selon l'une quelconque des revendications 1 à 7, dans lequel le revêtement sensible au rayonnement comprend en outre au moins un membre sélectionné parmi des liants polymères pouvant optionnellement contenir des fractions éthyléniquement insaturées, des colorants, des antioxidants, des améliorateurs de flux, des tensioactifs, des inhibiteurs de radicaux libres, et des particules inertes inorganiques ou organiques de granulométrie moyenne de 1 à 500 nm, et/ou dans lequel la surcouche comprend en outre au moins un membre sélectionné parmi des tensioactifs, des biocides et des particules inertes inorganiques ou organiques de granulométrie moyenne de 1 à 500 nm.

9. Procédé de production d'un élément sensible au rayonnement à travail négatif comme défini dans l'une quelconque des revendications 1 à 8, consistant à :

   (a) fournir un substrat prétraité optionnellement,
   (b) appliquer une composition de revêtement sensible au rayonnement comme défini dans l'une quelconque des revendications 1 à 4 et 8 comprenant

      (i) un composant polymérisable par radicaux libres,
      (ii) un sensibilisateur absorbant le rayonnement, et
      (ii) un coinitiateur qui comprend un sel d'onium sélectionné parmi des sels de diaryliodonium, d'alkoxypyridinium, de triarylsulfonium et de diarylalkylsulfonium ;

(c) appliquer une composition de revêtement de surcouche comprenant un alcool polyvinylique optionnellement fonctionnalisé,

**caractérisé en ce que** la teneur totale de métaux alcalins et de métaux alcalino-terreux dans la composition de revêtement de surcouche est telle que la teneur est égale ou inférieure à 0,5 $mg/m^2$ d'élément sensible au rayonnement lorsqu'elle est normalisée à un poids sec de couche de la surcouche de 1 $g/m^2$.

**10.** Procédé selon la revendication 9, dans lequel la composition de revêtement de surcouche comprend au moins 70 % en poids d'un alcool polyvinylique optionnellement fonctionnalisé sur la base de la teneur totale de solides de la composition de revêtement de surcouche.

**11.** Procédé selon la revendication 9 ou 10 en outre consistant à :

traiter la composition de revêtement de surcouche à l'aide d'une résine échangeuse de cations avant d'appliquer la composition de revêtement de surcouche sur le revêtement sensible au rayonnement obtenu à l'étape (b) ou
traiter une solution aqueuse de l'alcool polyvinylique avec une résine échangeuse de cations avant de l'utiliser pour la préparation de la composition de revêtement de surcouche qui est appliquée à l'étape (c).

**12.** Procédé selon la revendication 11, dans lequel la résine échangeuse de cations est une résine échangeuse de cations fortement acide comprenant des groupes d'acide sulfonique.

**13.** Procédé selon la revendication 11 ou 12, dans lequel la composition de revêtement de surcouche avant ou après le traitement avec la résine échangeuse de cations ou, simultanément à ce traitement, est en outre traitée avec une résine échangeuse d'anions.

**14.** Procédé de préparation d'un précurseur de plaque d'impression lithographique contenant une image, consistant à

(a) exposer selon une image un précurseur de plaque d'impression lithographique comme défini dans l'une quelconque des revendications 1 à 8
(b) enlever les régions non-exposées du revêtement du précurseur de plaque d'impression lithographique à l'aide d'un révélateur aqueux ayant un pH de 5 à 14, dans lequel le révélateur comprend optionnellement un polymère filmogène hydrophile.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2008150441 A
- US 7332253 B
- EP 2098367 A
- EP 0732625 A
- WO 9512625 A
- WO 2009004948 A
- EP 924570 A1, Fujimaki
- EP 1449650 A1, Goto
- US 4511645 A, Koike
- WO 6027857 A, Li
- WO 6309792 A, Hauck
- WO 6899994 A, Huang
- WO 7045271 A, Tao
- WO 7261998 A, Hayashi
- WO 7279255 A, Tao
- WO 7291438 A, Sakurai
- WO 7326521 A, Tao
- WO 7332253 A, Tao
- WO 7442486 A, Baumann
- WO 7452638 A, Yu
- WO 7524614 A, Tao
- WO 7560221 A, Timpe
- WO 7574959 A, Baumann
- WO 7615323 A, Strehmel
- US 20030064318 A, Huang
- US 20040265736 A, Aoshima
- US 20050266349 A, Van Damme
- US 6232038 B, Takasaki
- US 6514657 B, Sakurai
- US 20090092923 A, Hayashi
- WO 2004049068 A1
- WO 2004074929 A2
- WO 2004074930 A2
- US 6326122 B
- US 4327169 A
- US 4756993 A
- US 5156938 A
- WO 0029214 A
- US 6410207 B
- EP 1176007 A1
- WO 2004041544 A
- WO 200048836 A
- DE 102004003143
- EP 1969426 A
- EP 355387 A
- US 7574959 B
- DE 19936331
- US 7326521 B, Tao
- US 6569603 B, Furukawa
- EP 1182033 A1, Fujimaki
- US 4874686 A, Urabe
- US 6916595 B, Fujimaki
- US 7041416 B, Wakata
- US 7732118 B, Tao
- US 20090142695 A, Baumann
- EP 1182033 A
- US 6309792 B, Hauck
- US 6352812 B, Shimazu
- US 6893797 B, Munnelly
- US 7175949 B, Tao
- EP 2310909 A
- EP 2260351 A
- EP 1880978 A
- JP 2009086514 B
- US 7928166 B
- EP 2275258 A
- WO 9906890 A
- US 3458311 A
- US 4072527 A
- US 4072528 A
- EP 275147 A1
- EP 403096 A1
- EP 354475 A1
- EP 465034 A1
- EP 352630 A1
- US 5563023 A
- US 20110053085 A
- US 8105751 B
- US 13482151 B
- EP 1172699 A
- EP 1722275 A